# EUROPÄISCHE PATENTSCHRIFT

(11) **EP 1 861 886 B1**
(45) Veröffentlichungstag und Bekanntmachung des Hinweises auf die Patenterteilung: **06.07.2011**
(21) Anmeldenummer: 06722560.7
(22) Anmeldetag: 03.03.2006
(51) Int. Cl.: H01L 51/42, H01L 51/30

(54) **ORGANISCHES PHOTOAKTIVES BAUELEMENT**
ORGANIC PHOTOACTIVE COMPONENT
COMPOSANT PHOTOACTIF ORGANIQUE

(30) Priorität: 04.03.2005 DE 102005010978
(43) Veröffentlichungstag der Anmeldung: 05.12.2007
(73) Patentinhaber: Heliatek GmbH, 01187 Dresden (DE); Universitaet Ulm, 89069 Ulm (DE)
(72) Erfinder: PFEIFFER, Martin, 01139 Dresden (DE); UHRICH, Christian, 01309 Dresden (DE); PETRICH, Annette, 01129 Dresden (DE); SCHÜPPEL, Rico, 01307 Dresden (DE); SCHULZE, Kerstin, 01309 Dresden (DE); LEO, Karl, 01219 Dresden (DE); BÄUERLE, Peter, 89275 Elchingen-1 (DE); REINOLD, Egon, 89079 Gögglingen (DE); BRIER, Eduard, 89522 Heidenheim (DE)
(74) Vertreter: Bittner, Thomas L.
(86) Internationale Anmeldenummer: PCT/DE2006/000394
(87) Internationale Veröffentlichungsnummer: WO 2006/092134

(56) Entgegenhaltungen:
- EP-A- 1 443 093
- WO-A-2004/047185
- FR-A- 2 852 320
- US-A- 5 849 403
- US-A1- 2004 147 701
- TANG C W: "TWO-LAYER ORGANIC PHOTOVOLTAIC CELL" APPLIED PHYSICS LETTERS, AIP, AMERICAN INSTITUTE OF PHYSICS, MELVILLE, NY, US, Bd. 48, Nr. 2, 13. Januar 1985 (1985-01-13), Seiten 183-185, XP000996828 ISSN: 0003-6951 in der Anmeldung erwähnt
- BRABEC C J ET AL: "PLASTIC SOLAR CELLS" ADVANCED FUNCTIONAL MATERIALS, WILEY VCH, WIENHEIM, DE, Bd. 11, Nr. 1, Februar 2001 (2001-02), Seiten 15-26, XP001043648 ISSN: 1616-301X in der Anmeldung erwähnt

## Beschreibung

Die Erfindung bezieht sich auf ein organisches photoaktives Bauelement, insbesondere eine organische photovoltaische Zelle, mit einem Kontakt und einem Gegenkontakt sowie einem organischen Bereich, der mit dem Kontakt und dem Gegenkontakt elektrisch verbunden ist, wobei in dem organischen Bereich ein photoaktiver Bereich mit einem photoaktiven Heteroübergang zwischen einem elektroleitenden organischen Material und einem löcherleitenden organischen Material gebildet ist.

### Hintergrund der Erfindung

Die Forschung und Entwicklung auf dem Gebiet organischer photoaktiver Bauelemente, die in einer bekannten Ausführungsform als eine organische Solarzelle oder organische photovoltaische Zelle gebildet sind, hat in den letzten zehn Jahren stark zugenommen. Der maximale bisher berichtete Wirkungsgrade liegt bei 5,7% (vgl. Jiangeng Xue et al., Appl. Phys. Lett. 85 (2004) 5757). Auf diese Weise konnten für organische Solarzellen bisher typische Effizienzen von 10% bis 20%, wie sie für anorganische Solarzellen bekannt sind, noch nicht erreicht werden. Mit organischen Solarzellen sollten aber ähnliche Ergebnisse erreichbar sein wie für Solarzellen auf Basis anorganischer Materialien.

Die Vorteile organischer Solarzellen gegenüber anorganischen Solarzellen liegen vor allem in den niedrigeren Kosten. Die verwendeten organischen Halbleitermaterialien sind bei Herstellung in größeren Mengen sehr kostengünstig. Einen weiteren Vorteil bilden die teilweise sehr hohen optischen Absorptionskoeffizienten von bis zu 2x10⁵cm⁻¹, was die Möglichkeit bietet, mit geringem Material- und Energieaufwand sehr dünne aber effiziente Solarzellen herzustellen. Da bei dem Herstellungsprozess keine hohen Temperaturen benötigt werden, nämlich Substrattemperaturen von maximal nur etwa 110°C, ist es möglich, flexible großflächige Bauteile auf Plastikfolie oder Kunststoffgewebe herzustellen. Dieses eröffnet neue Anwendungsgebiete, welche den konventionellen Solarzellen verschlossen bleiben. Auf Grund der nahezu unbegrenzten Anzahl verschiedener organischer Verbindungen können die Materialien für ihre jeweilige Aufgabe maßgeschneidert werden.

In einem organischen photoaktiven Bauelement wird Lichtenergie in elektrische Energie umgewandelt. Im Gegensatz zu anorganischen Solarzellen, liegen im organischen Halbleitermaterial des organischen photoaktiven Bauelementes die Ladungsträgerpaare (Elektron-Loch-Paar) nach Lichtabsorption nicht frei vor, sondern sie bilden wegen einer weniger starken Abschwächung der gegenseitigen Anziehung ein Quasiteilchen, ein sogenanntes Exziton, nämlich ein gebundenes Elektron-Loch-Paar. Um die vorhandene Energie als elektrische Energie nutzbar zu machen, muss das so gebildete Exziton in freie Ladungsträger getrennt werden, also ein Elektron und ein Loch.

Da in organischen Solarzellen nicht ausreichend hohe Felder zur Trennung der Exzitonen zur Verfügung stehen, wird die Exzitonentrennung an photoaktiven Grenzflächen vollzogen. Die photoaktiven Grenzfläche kann als eine organische Donor-Akzeptor-Grenzfläche (vgl. C. W. Tang, Appl. Phys. Lett., 48 (2), 183-185 (1986)) oder als eine Grenzfläche zu einem anorganischen Halbleiter (vgl. B. O'Regan et al., Nature 1991, 353, 73) ausgebildet sein. Die freien Ladungsträger können nach der Trennung zu den Kontakten transportiert werden. Durch Verbinden der Kotakte über einen Verbraucher kann die elektrische Energie genutzt werden.

Ein organisches Material wird im Sinne der vorliegenden Anmeldung als löcherleitend bezeichnet, wenn in dem Material die Ladungsträger, die in Folge von Lichtabsoprtion und Ladungstrennung an einem Heteroübergang gebildeten werden ("photogenerierte Ladungsträger"), in Form von Löchern transportiert werden. In analoger Weise wird ein organisches Material als elektronenleitend bezeichnet, wenn in dem Material photogenerierte Ladungsträger in Form von Elektronen transportiert werden. Ein Grenzflächenbereich zwischen dem elektronenleitenden und dem löcherleitenden Material wird als Heteroübergang bezeichnet.

Ein Heteroübergang zwischen dem elektronenleitenden und dem löcherleitenden Material wird als photoaktiver Heteroübergang bezeichnet, wenn durch Lichtabsorption in dem elektronenleitenden und / oder dem löcherleitenden Material gebildete Anregungszustände, in denen Ladungsträger gebunden sind und die auch Exzitonen genannt werden, im Bereich des Heteroüberganges in die einzelnen Ladungsträger separiert werden, nämlich Elektronen und Löcher, die ihrerseits dann durch das elektronenleitende Material / das löcherleitende Material zu Kontakten transportiert werden, wo elektrische Energie abgegriffen werden kann.

Ein Heteroübergang zwischen dem elektronenleitenden und dem löcherleitenden Material wird als ein flacher Heteroübergang bezeichnet, wenn die Grenzfläche zwischen dem elektronenleitenden und dem löcherleitenden Material als eine im wesentlichen zusammenhängende Fläche zwischen den zwei Materialbereichen gebildet ist, nämlich einem Bereich aus dem elektronenleitenden Material und einem Bereich aus dem löcherleitenden Material (vgl. C. W. Tang, Appl. Phys. Lett., 48 (2), 183-185 (1986) oder N. Karl et al., Mol. Cryst. Liq. Cryst., 252,243-258 (1994)).

Ein Heteroübergang zwischen dem elektronenleitenden und dem löcherleitenden Material ist ein Volumen-Heteroübergang, wenn das elektronenleitende Material und das löcherleitende Material zumindest teilweise miteinander vermischt sind, so dass die Grenzfläche zwischen dem elektronenleitenden und dem löcherleitenden Material einen Vielzahl von Grenzflächenabschnitten umfasst, die über das Volumen der Materialmischung verteilt sind (vgl. beispielsweise C. J. Brabec et al., Adv. Funct. Mater., 11 (1), 15 (2001)).

Idealer Weise besitzen Materialien photoaktiver Schichten in organischen photoaktiven Bauelementen einen hohen Absorptionskoeffizienten in einem möglichst breiten Wellenlängenbereich, welcher auf das Sonnenspektrum abgestimmt ist. Das im Halbleitermaterial durch Absorption generierte Exziton sollte ohne große Energieverluste zum *photoaktiven Heteroüber*gang diffundieren können, wobei eine auftretende Stokes-Verschiebung möglichst gering sein sollte. Lange Exzitonen Diffusionslängen ermöglichen es, die Dicke der organischen Schichten zu maximieren, in denen absorbiertes Licht zum Photoastrom beiträgt, und somit die Effizienz des organischen photoaktiven Bauelementes weiter zu verbessern.

Des weiteren sind ein höchstes besetztes Energieniveau (HOMO) und ein niedrigstes unbesetztes Energieniveau (LUMO) des organischen Akzeptor-Materials (elektronenleitendes Material) und des organischen Donator-Materials (löcherleitendes Material) bevorzugt so zu wählen, dass einerseits eine effiziente Trennung der Exzitonen in Elektronen auf dem Akzeptor-Material und von Löchern auf dem Donator-Material stattfindet, andererseits die freie Energie des Systems von erzeugtem Elektron und Loch möglichst groß ist. Letzteres führt zu einer Maximierung der Leerlauf-Photospannung des Bauelements. Die Ladungsträger sollen schnell räumlich voneinander getrennt werden. Guter Elektronentransport auf dem Akzeptor-Material und guter Löchertransport auf Donor-Material sorgt für geringe Verluste und führt zu einem guten Füll-Faktor der Strom-Spannungskennlinie des organischen photoaktiven Bauelementes.

Organische Solarzellen sind in verschiedenen Ausführungen aus dem Stand der Technik bekannt:
- Ein Kontaktmetall hat eine große und das andere Kontaktmetall eine kleine Austrittsarbeit, so dass mit der organischen Schicht eine Schottky-Barriere ausgebildet wird (vgl. US 4,127,738).
- Die photoaktive Schicht besteht aus einem organischen Halbleiter in einem Gel oder einem Bindemittel (US 3,844,843, US 3,900,945, US 4,175,981 und US 4,175,982).
- Es wird eine Ladungsträgertransportschicht gebildet, die kleine Partikel mit einer Größe von 0.01 bis 50µm enthält, welche den Ladungsträgertransport übernehmen (vgl. US 5,965,063).
- Eine Schicht der Solarzelle enthält zwei oder mehr Arten von organischen Pigmenten, die verschiedene spektrale Charakteristika besitzen (vgl. JP 04024970).
- Eine Schicht der Solarzelle enthält ein Pigment, das Ladungsträger erzeugt, und zusätzlich ein Material, das die Ladungsträger abtransportiert (vgl. JP 07142751).
- Polymerbasierende Solarzellen wurden hergestellt, die Kohlenstoffteilchen als Elektronen-Akzeptoren enthalten (vgl. US 5,986,206).
- Eine Dotierung von Mischsystemen wurde zur Verbesserung der Transporteigenschaften in Mehrschichtsolarzellen vorgesehen (vgl. DE 102 09 789).
- Anordnung einzelner Solarzellen übereinander (Tandemzelle) wurden gebildet (US 4,461,922; US 6,198,091 und US 6,198,092). Tandemzellen können mittels Verwendung von p-i-n-Strukturen mit dotierten Transportschichten großer Bandlücke weiter verbessert werden (vgl. DE 103 13 232).

Aus dem Dokument US 5,093,698 ist die Dotierung organischer Materialien bekannt. Durch Beimischung einer Dotiersubstanz, nämlich einer Substanz mit hoher Elektronenaffinität zur p-Dotierung oder einer Substanz mit geringer Ionisierungsenergie zu n-Dotierung, werden die Gleichgewichtsladungsträgerkonzentration in der dotierten Schicht erhöht und die Leitfähigkeit gesteigert. Bei dem Stand der Technik aus dem Dokument US 5,093,698 werden die dotierten Schichten als Injektionsschichten an der Grenzfläche zu den Kontakten in elektrolumineszierenden Bauelementen verwendet.

In dem Dokument US 5,849,403 sind organische Dünnschichten beschrieben aus einem Material mit Donor- und Akzeptor-Molekülen, die sich zueinander anordnen und hierbei komplexe Kristallstrukturen bilden. Es wird zwischen neutralen Komplexen, nämlich Donor- und Akzeptor-Molekülen ohne Ladungstransfer, sowie ionischen Komplexen unterschieden, bei denen ein partieller Ladungstransfer stattfindet. In beiden Fällen sind die Komplexpartner frei von kovalenten Bindungen.

Im Dokument US 2004/0147701 A1 sind chemische Verbindungen mit einer Elektronen-Donorgruppe, einer Elektronen-Akzeptorgruppe sowie einer konjugierten Brücke zwischen der Elektronen-Donorgruppe und der Elektronen-Akzeptorgruppe beschrieben. In einer Ausführungsform ist die folgende Struktur gebildet: Akzeptor-Brücke-Donor-Brücke-Akzeptor.

### Zusammenfassung der Erfindung

Aufgabe der Erfindung ist es, ein organisches photoaktives Bauelement, insbesondere eine organische photovoltaische Zelle, der eingangs genannten Art mit einer verbesserten Ausbeute zu schaffen.

Die Aufgabe wird gelöst durch organische, photoaktive Bauelemente nach den unabhängigen Ansprüche 1, 2 und 3.

Aufgrund der Nutzung der konjugierten Akzeptor-Donor-Akzeptor-Oligomere (A-D-A'-Oligomere) und der konjugierten Donor-Akzeptor-Donor-Oligomere (D-A-D'-Oligomere) ergeben sich vielfältige Vorteile gegenüber dem Stand der Technik, die im Folgenden näher ausgeführt werden.

Bei der Nutzung der A-D-A'- / D-A-D'-Oligomere mit ausgedehntem Donor-Block als lö-cherleitende Komponente in einem photoaktiven Heteroübergang, sei es ein flacher Heteroübergang oder ein Volumen-Heteroübergang, für ein elektronenleitendes Material werden durch die Exzitonentrennung am Heteroübergang Löcher auf dem Oligomer generiert, die innerhalb des Donor-Blocks / der Donor-Blöcke delokalisiert werden. Durch die Delokalisierung sinkt die elektrostatische Wechselwirkung zu dem Elektron, das sich nach der Trennung auf dem elektronenleitenden Material befindet, so dass die beiden Ladungsträger effizient und schon durch geringe elektrische Felder getrennt werden können. Durch die Delokalisierung der Löcher haben diese eine hohe Beweglichkeit und können schnell, effizient und mit geringen Rekombinationsverlusten abtransportiert werden. Das ist insbesondere bei Volumen-Heteroübergängen von Vorteil, bei denen in einem gemischten Volumen aus löcherleitender und elektronenleitender Komponente beide Ladungsträger koexistieren und, solange sie das Volumen nicht verlassen haben, in Gefahr sind zu rekombinieren.

In analoger Weise werden die A-D-A'- / D-A-D'-Oligomere, welche einen ausgedehnten Akzeptor-Block umfassen, als elektronenleitende Komponente in einem photoaktiven Hetero-übergang für ein löcherleitendes Material verwendet. Die Vorteile für die Exzitonentrennung und den Elektronentransport ergeben sich analog aus der Delokalisierung der Elektronen auf dem Akzeptor-Block / den Akzeptor-Blöcken.

Bei der Nutzung der A-D-A'- / D-A-D'-Oligomere als elektronenleitende und / oder als löcherleitende Komponente in einem flachen Heteroübergang wurde überraschender Weise gefunden, dass auch Oligomere ohne ausgedehnten Akzeptor-Block in Kombination mit einem geeigneten Löcherleiter vorteilhaft als Elektronenleiter eingesetzt werden können, obwohl die bei der Exzitonentrennung entstehenden Elektronen hier nicht auf dem Oligomer delokalisiert werden. Eine derartige Verwendung führt in Volumen-Heteroübergängen zu schr geringen Wirkungsgraden aufgrund der geringen Elektronenbeweglichkeit und folglich hohen Rekombinationsverlusten. In flachen Hetcroübcrgängen kommen alle Vorteile der vorgeschlagenen Materialklasse mit Ausnahme einer erhöhten Beweglichkeit der photogenerierten Ladungsträger voll zum Tragen. Das Problem der geringen Ladungsträgerbeweglichkeit wird Dadurch überwunden, dass es bei Verwendung eines flachen Heteroübergangs kein Volumen gibt, in dem Elektronen und Löcher koexistieren und damit keine Rekombination mehr stattfinden kann, wenn die Exzitonen einmal getrennt sind.

Oligomere zeichnen sich im Unterschied zu polymeren Verbindungen dadurch aus, dass sie eine wohl definierte Anzahl von Monomeren (Wiederholeinheiten) umfassen, die typischerweise zwischen drei und zehn liegt. Die Oligomere bilden so Moleküle mit einer definierten Anzahl von Monomeren. Sie weisen damit auch eine wohldefinierte molare Masse auf, typischerweise von weniger als 1200g/mol, und sind frei von undefinierten, möglicherweise reaktiven Gruppen am Ende der Molekülkette, wie sie als Nebenprodukt einer Polymerisations-Kettenreaktion in Polymeren vorliegen können.

Technologische Vorteile von Oligomeren sind weiterhin die Verdampfbarkeit im Vakuum und die hiermit verbundene Möglichkeit der Reinigung durch Gradientensublimation. Hierdurch ergibt sich für aufdampfbare Oligomere die Möglichkeit, nahezu beliebig komplexe Multischichtsysteme durch sequentielles Aufdampfen verschiedener reiner oder gemischter Materialien herzustellen. Mischschichten mit kontrollierter Komposition werden durch simultanes Verdampfen verschiedener Materialien aus verschiedenen Verdampferquellen auf ein Substrat hergestellt, wobei die Aufdampfraten beispielsweise mittels Schwingquarz-Monitoren separat kontrolliert werden können.

Auf diese Weise können auch kontrolliert p- und n-dotierte Schichten und photoaktive Donor-Akzeptro-Mischschichten hergestellt werden. Die kann die Morphologie der Mischschichten mittels Wahl der Substrattemperatur während des Bedampfens durch die Substrattemperatur über einen großen Bereich variiert werden. Auf kalten Substraten entsteht typischerweise eine homogene, weitgehend amorphe Mischung, während es bei höheren Substrattemperaturen zunehmend zur Nanophasenseparation und ggf. zur Ausbildung von kristallinen Nanodomänen kommt. So gelingt die Kontrolle über die Phasenseparation auf der Größenskala von 10 bis 100nm, was insbesondere für sogenannte photoaktive Volumen-Heteroübergänge von Vorteil ist. Für Polymere, die durch Aufschleudern gemischter Lösungen aufgebracht werden, kommt es häufig zu einer zu starken Phasenseparation, insbesondere wenn eine der Komponenten eine zu geringe Löslichkeit hat.

Mit Hilfe der Nutzung der A-D-A'-Oligomere und der D-A-D'-Oligomere nach den verschiedenen Aspekten der Erfindung ist es gelungen, im Vergleich zu allen bekannten Solarzellen auf Basis von konjugierten Oligomeren weit höhere photovoltaische Wirkungsgrade zu erreichen. Vergleichbare Wirkungsgrade wurden bisher nur mit Polythiophen und mit großen kondensierten Molekülen wie Phthalocyanin oder Perylenderivaten erreicht, welche jedoch keinen Oligomer-Charakter aufweisen. Der Grund für diesen Durchbruch wird in einer Kombination von einzigartigen Eigenschaften der verwendeten Materialklasse und gezieltem Einsatz in organischen photoaktiven Bauelementen gesehen, so dass die Materialeigenschaften optimal ausgenutzt werden.

Die A-D-A'-Oligomere und D-A-D'-Oligomere zeichnen sich im Vergleich zu üblichen Oligomeren durch einen intramolekularen Donor-Akzeptor-Effekt schon in Lösung aus, was zu einem stark zu längeren Wellenlängen hin verschobenen optischen Absorptionsspektrum führt. Hierdurch wird ein Problem konventioneller Oligomere für die Photovoltaik überwunden, welche eine höhere optische Bandlücke haben als analoge Polymere.

Bei der Bildung von dünnen Schichten aus den A-D-A'- / D-A-D'-Oligomeren verbreitert sich das Absorptionsspektrum und verschiebt sich weiter hin zu längeren Wellenlängen, wodurch der spektrale Überlapp mit dem Sonnenspektrum weiter verbessert wird. Im Gegensatz dazu wird bei konventionellen Oligomeren in dünnen Schichten häufig eine Verschiebung des Absorptionsmaximums hin zu kürzeren Wellenlängen beobachtet (vgl. zum Beispiel Daten für Quinquethiophen in D. Fichou and C. Ziegler, Chap. 4, S. 227 in: D. Fichou (Ed.) Handbook of Oligo- and Polythiophenes, Wiley-VCH, Weinheim, 1999, oder Tabelle 1 in: J. Gierschner et al., J. Chem. Phys. 123, S. 144914 (2005)).

Die A-D-A'- / D-A-D'-Oligomere weisen eine intensive und relativ zum Absorptionsmaximum nur geringfügig zu längeren Wellenlängen hin verschobene Fluoreszenz auf, da der op-tisch erlaubte Übergang gleichzeitig der energieärmste Anregungszustand ist, so dass wenig Energie durch Relaxation im Exzitonenband verloren geht. Das Verhältnis aus optischer Bandlücke und maximal erreichbarer Photospannung ist damit günstiger als für übliche Oligomere, bei denen durch sogenannte H-Aggregat-Bildung in dünnen Schichten häufig eine stark zu längeren Wellenlängen hin verschobene, sehr ineffiziente Fluoreszenz auftritt, was auf hohe Energieverluste durch Relaxationsprozesse im Exzitonenband direkt nach der optischen Anregung und / oder Exzimerbildung zurückzuführen ist (siehe J. Gierschner et al., J. Chem. Phys. 123, S. 144914 (2005)).

Die Energien eines niedrigsten unbesetzten Orbitals (LUMO) und / oder ein höchsten besetztes Orbitals (HOMO) von üblichen Donor- / Akzeptor-Oligomeren lassen sich durch den Einbau in die A-D-A'- / D-A-D'-Oligomere energetisch für die Anforderungen in organischen photoaktiven Bauelementen optimieren. Beispielsweise kann der Einbau von konventionellen Donor-Oligomeren in die A-D-A'- / D-A-D'-Oligomere zur Absenkung des HOMO und zu einer noch stärker ausgeprägten Absenkung des LUMO im Vergleich zu dem entsprechenden konventionellen Donor-Oligomer führen, was simultan zur Reduzierung der optischen Bandlücke und zur Erhöhung der Photospannung führt, wenn das A-D-A'- D-A-D'-Oligomer als Löcherleiter in einem photoaktiven Heteroübergang mit einem gegebenen Elektronenleiter, zum Beispiel Fulleren C60, eingesetzt wird.

Im Vergleich zu einfachen Donor-Akzeptor-Oligomeren (D-A-Oligomer) haben die A-D-A'-/ D-A-D'-Oligomere ein geringeres oder verschwindendes Dipolmoment, was die dipolare Unordnung in amorphen oder polykristallinen Festkörpern, beispielsweise dünnen Schichten, senkt. Dipolare Unordnung ist zu vermeiden, da sie die Ladungsträgerbeweglichkeit drastisch senkt (vgl. P. M. Borsenberger et al., J. Chem. Phys., 95 (7), 5327-5331 (1991).)

Die A-D-A'- / D-A-D'-Oligomere haben weiterhin den Vorteil, dass sie zumindest einen ausgedehnten Donor- oder einen ausgedehnten Akzeptor-Block umfassen. Mit Hilfe der ausgedehnten Blöcke wird eine gewünschte Delokalisierung der mittels Lichtabsorption gebildeten Exzitonen erreicht, so dass die anschließende Ladungsträgertrennung optimiert ist. Alternierende D-A-Moleküle mit einer Monomerfolge D-A-D-A-D... haben hingegen das Problem, dass die On-Chain-Bandbreite abnimmt, da sich zum Beispiel die HOMO-Wellenfunktion auf die Donor-Bausteine konzentriert und die Wechselwirkung unter den HOMO-Orbitalen, die zur Bandaufspaltung führt, abnimmt, wenn Akzeptor-Komponenten dazwischen liegen, die kein Niveau anbieten, das mit den Donor-HOMO in Resonanz liegt. Dadurch nimmt die effektive Konjugationslänge ab und schon kleinste Störungen führen dazu, dass Ladungsträger weitgehend aus einem einzelnen Monomer lokalisiert werden, was sich wiederum nachteilig auf Exzitonentrennung und Ladungsträgertransport auswirkt.

Zum weiteren Verständnis der Erfindung werden nachfolgend in der vorliegenden Anmeldung verwendete Bezeichnungen noch näher erläutert.

Ein konjugierte A-D-A'-Oligomer mit ausgedehntem Donor- / Akzeptor-Block wird hierbei zur Vereinfachung auch als A-D-A'-BCO ("Akzeptor-Donor-Akzeptor-Block-Cooligomer") bezeichnet. Analog wird ein konjugiertes D-A-D'-Oligomere mit ausgedehntem Donor- / Akzeptor-Block auch als D-A-D'-BCO ("Donor-Akzeptor-Donor-Block-Cooligomer") bezeichnet. Hierbei gilt, dass zumindest ein ausgedehnter Donor-Block oder zwei ausgedehnte Akzeptor-Blöcke in dem A-D-A'-BCO und ein ausgedehnter Akzeptor-Block oder zwei ausgedehnte Donor-Blöcke in dem D-A-D'-BCO auftreten.

Eine Einheit im Sinne der vorliegenden Anmeldung ist eine Gruppe von Atomen innerhalb einer chemischen Verbindung, welche mindestens ein Monomer umfasst. Ein Monomer im Sinne der vorliegenden Anmeldung ist eine Gruppe von Atomen innerhalb einer chemische Verbindung, welche zumindest eine Untergruppe von Atomen mit einem konjugierten π-Elektronensystem umfasst und welche die Bedingung erfüllt, dass die Gruppe von Atomen nicht aus mehreren gleichartigen, nur durch eine Bindung verbundenen Einheiten aufgebaut ist.

Eine Einheit bildet eine Akzeptor-Einheit relativ zu einer Donor-Einheit, wenn ein niedrigstes unbesetztes Orbital (LUMO) der Akzeptor-Einheit mindestens 0.2eV, bevorzugt mindestens 0.3eV energetisch tiefer liegt als ein niedrigstes unbesetztes Orbital (LUMO) der Donor-Einheit. Zur weiteren Optimierung der Akzeptorwirkung kann bei einer zweckmäßigen Ausgestaltung vorgesehen sein, dass ein höchstes besetztes Orbital (HOMO) der Akzeptor-Einheit mindestens 0.1eV, bevorzugt mindestens 0.2eV energetisch tiefer liegt als ein höchstes besetztes Orbital (HOMO) der Donor-Einheit.

Analog gilt, dass eine Einheit eine Donor-Einheit relativ zu einer Akzeptor-Einheit bildet, wenn ein höchstes besetztes Orbital (HOMO) der Donor-Einheit mindestens 0.2eV, bevorzugt mindestens 0.3eV energetisch höher liegt als ein höchstes besetztes Orbital (HOMO) der Akzeptor-Einheit. Zur weiteren Optimierung der Donorwirkung kann bei einer zweckmäßigen Ausgestaltung vorgesehen sein, dass ein niedrigstes unbesetztes Orbital (LUMO) der Donor-Einheit mindestens 0.1eV, bevorzugt mindestens 0.2eV energetisch höher liegt als ein niedrigstes unbesetztes Orbital (LUMO) der Akzeptor-Einheit.

Umfasst mindestens eine der beteiligten Einheiten mehrere Monomere, bildet eine Einheit eine Akzeptor-Einheit mit i (i ≥ 1) Monomeren Aᵢ relativ zu einer Donor-Einheit mit j (j ≥ 1) Monomeren Dⱼ, wenn in der Akzeptor-Einheit zumindest für ein zu der Donor-Einheit benachbartes Monomer ein niedrigstes unbesetztes Orbital (LUMO) mindestens 0.2eV, bevorzugt mindestens 0.3eV energetisch tiefer liegt als ein niedrigstes unbesetztes Orbital (LUMO) eines zugehörigen Nachbarmonomers in der Donor-Einheit welches in der Donor-Einheit den Nachbar zu dem benachbarten Monomer in der Akzeptor-Einheit bildet. In einer bevorzugten Weiterbildung gelten die genannten energetischen Relationen für alle Monomere der Akzeptor-Einheit relativ zu allen Monomeren der Donor-Einheit. Die vorangehenden Ausführungen zur weiteren Optimierung der Akzeptorwirkung gelten entsprechend. Es kann auch vorgesehen sein, dass die Akzeptor-Einheit mehrere Monomere und die Donor-Einheit nur ein Monomer umfasst und umgekehrt.

Umfasst mindestens eine der beteiligten Einheiten mehrere Monomere, bildet eine Einheit auch dann eine Akzeptor-Einheit mit i (i ≥ 1) Monomeren Aᵢ relativ zu einer Donor-Einheit mit j (j ≥ 1) Monomeren Dⱼ, wenn folgende Bedingung, die experimentell beispielsweise mittels elektrochemischer Messungen in Lösung und / oder mittels Kombination aus Photoelektronen-Spektroskopie und optischer Spektroskopie am Festkörper nachprüfbar ist, erfüllt ist: Das Anhängen der Akzeptor-Einheit an eine oder beide Seiten der Donor-Einheit führt zu einer Absenkung eines niedrigsten unbesetzten Orbitals (LUMO) des auf diese Weise gebildete Moleküls um mindestens 0.2eV, bevorzugt um mindestens 0.3eV relativ zu einem niedrigsten unbesetzten Orbital (LUMO) der Donor-Einheit, während ein höchstes besetztes Orbital (HOMO) des so gebildete Moleküls energetisch gleich bleibt, abgesenkt oder um maximal 0.1eV angehoben wird.

Eine Einheit ist im Sinne der vorliegenden Anmeldung auch eine Donor-Einheit mit i (i ≥ 1) Monomeren Dᵢ relativ zu einer Akzeptor-Einheit mit j (j ≥ 1) Monomeren Aj, wenn in der Donor-Einheit zumindest für ein zu der Akzeptor-Einheit benachbartes Monomer ein höchstes besetztes Orbital (HOMO) mindestens 0.2eV, bevorzugt mindestens 0.3eV energetisch höher liegt als ein höchstes besetztes Orbital (HOMO) eines zugehörigen Nachbarmonomers in der Akzeptor-Einheit, welches in der Akzeptor-Einheit den Nachbar zu dem benachbarten Monomer in der Donor-Einheit bildet. Im bevorzugten Fall gelten die genannten energetischen Relationen für alle Monomere der Donor-Einheit relativ zu allen Monomeren der Akzeptor-Einheit. Die obigen Ausführungen zur weiteren Optimierung der Donorwirkung gelten entsprechend.

Eine Einheit ist im Sinne der vorliegenden Anmeldung auch eine Donor-Einheit mit i (i ≥ 1) Monomeren Dᵢ relativ zu einer Akzeptor-Einheit mit j (j ≥ 1) Monomeren Aⱼ, wenn folgende Bedingung, die experimentell beispielsweise mittels elektrochemischer Messungen in Lösung und / oder mittels Kombination aus Photoelektronen-Spektroskopie und optischer Spektroskopie am Festkörper nachprüfbar ist, erfüllt ist: Das Anhängen der Donor-Einheit an eine oder beide Seiten der Akzeptor-Einheit führt zu einer Anhebung eines höchsten besetzten Orbitals (HOMO) des auf diese Weise gebildete Moleküls um mindestens 0.2eV, bevorzugt um mindestens 0,3eV relativ zu einem höchsten besetzten Orbital (HOMO) der Akzeptor-Einheit, während ein niedrigstes unbesetztes Orbital (LUMO) des so gebildeten Moleküls energetisch gleich bleibt, angehoben oder um maximal 0.1eV abgesenkt wird.

Eine Akzeptor-Einheit ist ein ausgedehnter Akzeptor-Block, wenn die Akzeptor-Einheit (i) mindestens zwei Monomere, bevorzugt mindestens drei Monomere umfasst und / oder wenn die Akzeptor-Einheit (ii) mindestens acht, bevorzugt mindestens zehn Atome mit einem gemeinsamen konjugierten π-Elektronensystem umfasst, die von Atomen eines oder mehrerer chemischen Elemente aus der folgenden Gruppe von Elementen gebildet sind: C, N, B, P, S, Si und O. Letzteres kann insbesondere auch dann erfüllt sein, wenn die Akzeptor-Einheit nur ein Monomer umfasst. In analoger Weise ist ein ausgedehnter Donor-Block auf Basis einer Donor-Einheit bestimmt. Mit Hilfe der ausgedehnten Blöcke wird eine gewünschte Delokalisierung der mittels Lichtabsorption gebildeten Exzitonen unterstützt, so dass die anschließende Ladungsträgertrennung optimiert ist.

Ein ausgedehnter Akzeptor-Block zeichnet sich in einer bevorzugten Weiterbildung der Erfindung dadurch aus, dass der ausgedehnte Akzeptor-Block zumindest einen ausgedehnten Akzeptor-Unterblock enthält, der seinerseits ein ausgedehnter Block im obigen Sinne ist und bei dem das niedrigste unbesetzte Orbital (LUMO) aller an dem Akzeptor-Unterblock beteiligten Monomere in einem energetischen Intervall mit einer Breite von maximal etwa 0.5eV, bevorzugt von maximal etwa 0.3eV liegt, so dass eine Wellenfunktion für Elektronen möglichst gleichmäßige große Koeffizienten auf den beteiligten Monomeren des ausgedehnten Akzeptor-Unterblocks aufweist. Analog gilt, dass ein ausgedehnter Donor-Block in einer bevorzugten Weiterbildung der Erfindung zumindest einen ausgedehnten Donor-Unterblock enthält, der seinerseits ein ausgedehnter Block im obigen Sinne ist und bei dem das höchste besetzte Orbital (HOMO) aller an dem ausgedehnten Donor-Unterblock beteiligten Monomere in einem energetischen Intervall mit einer Breite von maximal etwa 0.5eV, bevorzugt von maximal etwa 0.3eV liegt, so dass eine Wellenfunktion für Löcher möglichst gleichmäßige große Koeffizienten auf den beteiligten Monomeren des ausgedehnten Donor-Unterblocks aufweist.

Bevorzugt erfolgt die Ladungstrennung nach der Lichtabsorption so, dass die hierbei auf dem Oligomer gebildete Ladungsträgersorte (Elektronen; Löcher) innerhalb des ausgedehnten Blockes delokalisiert ist, was sowohl die Ladungstrennung als auch den anschließenden Ladungsträgertransport verbessert. Die Delokalisierung von Ladungsträgern reduziert ferner die lokale Spindichte von geladenen Molekülen, was generell die Reaktivität der radikalischen Spezies verringert und damit deren elektrochemische Stabilität erhöht.

Bei einer zweckmäßigen Weiterbildung der Erfindung ist vorgesehen, dass in dem konjugierten Akzeptor-Donor-Akzeptor-Oligomer (A-D-A'-Oligomer) die Akzeptor-Einheit (A) und die weitere Akzeptor-Einheit (A') aus Monomeren der gleichen Art gebildet sind. Ein derartiger Aufbau der Oligomere hat den Vorteil, dass eine energetische Unordnung auftritt, wenn ein Molekül im Festkörper unregelmäßig, beispielsweise spiegelverkehrt eingebaut wird, gering bleibt und so auch bei Unordnung relativ hohe Ladungsträgerbeweglichkeiten erzielt werden können. Dies gilt in analoger Weise für konjugierte Donor-Akzeptor-Donor-Oligomere (D-A-D'-Oligomer), für die die Donor-Einheit (D) und die weitere Donor-Einheit (D') aus Monomeren der gleichen Art gebildet sind.

Eine vorteilhafte Ausführungsform der Erfindung sieht vor, dass in dem konjugierten Akzeptor-Donor-Akzeptor-Oligomer (A-D-A'-Oligomer) die Donor-Einheit (D) eine Monomerfolge der Art D₁D₂ ... Dₘ₋₁Dₘ (m > 2) aufweist, wobei ein höchstes besetztes Orbital (HOMO) der Monomere D₁ und Dₘ jeweils um mindestens 0.2eV energetisch höher liegt als ein höchstes besetztes Orbital (HOMO) der übrigen Monomere D₂ ... Dₘ₋₁. Der Hierdurch wird die elek-tronenziehende Wirkung der Akzeptor-Einheiten auf die Donor-Monomere am Rand des Donor-Blocks Dadurch zumindest teilweise kompensiert, dass hier Monomere verwendet werden, die in isolierter Form besonders elektronenreich sind, zum Beispiel EDOT-Monomere, falls es sich bei den anderen Monomeren um Thiophenringe handelt. Dadurch wird einer Konzentration der photogenerierten Löcher auf Monomere, die nicht in unmitelbarer Nachbarschaft der Akzetorgruppen sind, entgegengewirkt und die Löcherwellenfunktion kann sich optimal und gleichmäßig auf den gesamten Donor-Block verteilen.

In analoger kann in zweckmäßiger Weisevorgesehen sein, dass in dem konjugierten Donor-Akzeptor-Donor-Oligomer (D-A-D'-Oligomer) die Akzeptor-Einheit (A) eine Monomerfolge der Art A₁A₂ ... Aₘ₋₁Aₘ (m > 2) aufweist, wobei ein niedrigste unbesetztes Orbital (LUMO) der Monomere A₁ und Aₘ jeweils um mindestens 0.2eV energetisch tiefer liegt als ein niedrigstes unbesetztes Orbital (LUMO) der übrigen Monomere A₂ ... Aₘ₋₁.

Bei einer bevorzugten Weiterbildung ist vorgesehen, dass in dem konjugierten Akzeptor-Donor-Akzeptor-Oligomer (A-D-A'-Oligomer) eine Spiegel- oder eine Punktsymmetrie gebildet ist. Ebenso kann in einer zweckmäßigen Fortbildung der Erfindung vorsehen sein, dass in dem konjugierten Donor-Akzeptor-Donor-Oligomer (D-A-D'-Oligomer) eine Spiegel- oder eine Punktsymmetrie gebildet ist. Der Vorteil einer Spiegel- oder Punktsymmetrie besteht darin, dass das statische Dipolmoment der Oligomere minimiert wird und so dipolare Unordnung, welche die Ladungsträgerbeweglichkeit reduziert, vermieden wird. Ohnehin führen hohe Symmetrien dazu, dass leichter hochgeordnete Schichten gebildet werden können, da bestimmt Arten von Punktfehlern (gespiegelte Moleküle) von vorne herein ausgeschlossen sind.

Bei einer zweckmäßigen Weiterbildung der Erfindung ist vorgesehen, dass der Kontakt und / oder der Gegenkontakt als eine transparente oder eine semitransparente Elektrode ausgeführt sind.

Ein bevorzugte Weiterbildung der Erfindung kann vorsehen, dass zwischen dem Kontakt und dem Gegenkontakt zumindest eine anorganische Schicht aus einem oder mehreren anorganischen Materialien gebildet ist.

Eine vorteilhafte Ausführungsform der Erfindung sieht vor, dass das konjugierte Akzeptor-Donor-Akzeptor-Oligomer (A-D-A'-Oligomer) und / oder das Donor-Akzeptor-Donor-Oligomer (D-A-D'-Oligomer) als ein Oligomer gebildet sind, welches an mindestens eine Akzeptor-Einheit (A; A') Nitrilgruppen aufweist und bei dem mindestens eine Donor-Einheit (D; D') periphere Wasserstoffatome aufweist, wie beispielsweise bei Thiophenderivaten. Hier kommt es zu einer anziehenden intermolekularen Nitril-Wasserstoff-Wechselwirkung zwischen den Akzeptor-Einheiten eines Moleküls mit der Donor-Einheit der Nachbarmoleküle, so dass eine vorteilhafte Anordnung der Moleküle untereinander mit starkem Versatz in den Stapeln unterstützt wird. Die Bildung solcher Nitril-Wasserstoff-Brücken ist spektroskopisch nachweisbar, da sie zu einer charakteristschen Verschiebung der Schwingungsmoden führt, an denen das Wasserstoffatom beteiligt ist.

Zweckmäßig kann vorgesehen sein, dass der Kontakt eine Anode ist und zwischen der Anode und dem photoaktiven Heteroübergang eine p-dotierte organische Schicht angeordnet ist (M-i-p-Diode).

Bei einer bevorzugten Weiterbildung ist vorgesehen, dass der Gegenkontakt eine Kathode ist und zwischen der Kathode und dem photoaktiven Heteroübergang eine n-dotierte organische Schicht angeordnet ist (M-i-n- oder n-i-p-Diode).

Eine zweckmäßige Fortbildung der Erfindung kann vorsehen, dass der organische Bereich zumindest teilweise mittels thermischen Verdampfen im Hochvakuum oder Verdampfen organischer Materialien in ein inertes Trägergas, welches die verdampften organischen Materialien zu einem Substrat transportiert (,,*Organic Vapor Phase Deposition"*), abgeschieden ist.

Bei einer vorteilhaften Ausführungsform der Erfindung ist vorgesehen, dass der organische Bereich zumindest teilweise aus einer oder mehreren flüssigen Lösungen mittels Aufschleudem, Aufrakeln und / oder Drucken abgeschieden ist.

Ein bevorzugte Weiterbildung der Erfindung kann vorsehen, dass die Donor-Einheit (D) und / oder die weitere Donor-Einheit (D') mindestens eines der folgenden donorartigen Monomere mit oder ohne zusätzliche periphere Substituenten enthält: Thiophen; Thienopyrazin; Benzothiadiazol; Ethylen-Dioxothiophen (EDOT) bzw. Ethylendithiothiophen; Isothianaphthen (ITN); Verbrückte Dithiopheneinheit; 1,3-Thiazol; 1,3,4-Thiadiazol; Thieno-Thiadiazol; Thieno-Selenodiazol; Phenyl; Naphthyl; Anthrazen; Tetrazen; Pentazen; Vinylen; Phenylen-Vinylen; Pyridine; Pyrimidine; Porphyrin; Phthalocyanine; Fluoren; Carbazol; Perylen; Pyren und Di- oder Triarylamin.

Eine zweckmäßige Fortbildung der Erfindung kann vorsehen, dass die Akzeptor-Einheit (A) und / oder die weitere Akzeptor-Einheit (A') mindestens eines der folgenden akzeptorartigen Monomere mit oder ohne zusätzliche periphere Substituenten enthält: Cyano- Bicyano oder Tricyano-Vinylen; verbrückte Dithiopheneinheit mit elektronenziehender Brücke; Benzothiadiazol; Oxadiazol; Triazol; Benzimidazol; Quinoline; Quinoxaline; Pyrazoline; Naphthalen-Dicarbonsäure-Anhydride; Naphthalene-Dicarbonsäure-Imide; Naphthalene-Dicarbonsäure-Imidazole; halogenierte Homo- und Heterozyklen; Di- oder Triarylboryl; Dioxaborin-Derivate; Chinoide Strukturen und Aryle mit Keton- oder Dicyanomethan-Substituenten.

Weiterhin kann eine Vorrichtung mit einer gestapelten Anordnung von mehreren aufeinander gestapelten organischen photoaktiven Bauelementen, insbesondere organischen photovoltaischen Zellen, in einer der vorgenannten Ausgestaltungen vorgesehen sein.

### Beschreibung bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines photoaktiven organischen Bauelementes;
- Fig. 2: die chemische Struktur von Bis(dicyanovinylen)-Oligothiophen-Derivaten: Bei- spiel für chemische Struktur von Bis(dicyanovinylen)-Oligothiophen-Derivaten, wobei n ≥ 1 und R1 - R4 beliebige Reste sind, bevorzugt ein Wasserstoffatom oder Halogen-, Nitril-, Alkyl-, Alkoxy- oder Arylreste;
- Fig. 3: ein Absorptionsspektrum von DCV3T in Lösung (Kreise) und in einer 30nm dik- ken Aufdampfschicht auf Quarzglas (Vierecke);
- Fig. 4: eine Kristallstruktur von DCV3T, bestimmt aus Röntgenbeugungsexperimenten;
- Fig. 5: eine allgemeine Spurfolge für konjugierte A-D-A-Oligomere mit ausgedehn- tem Donor-Block mit Spiegel- / Punktsymmetrie und Dicyanovinylen als Akzep- tor-Gruppe;
- Fig. 6: Beispiele für Donor-Einheiten in konjugierten A-D-A'- / D-A-D'-Oligomeren;
- Fig. 7: Beispiele für Akzeptor-Einheiten auf Basis der Dioxaborin-Gruppe;
- Fig. 8: Beispiele für Akzeptor-Einheiten, die in konjugierten A-D-A'-Oligomeren ver- wendet werden können;
- Fig. 9: konjugierte A-D-A'-Oligomere, bei denen an beiden Enden des ausgedehnten Donor-Blocks starke Donor-Einheiten angeordnet sind, wobei Y1 und Y2 Sauer- stoff- oder Schwefelatome und R1 - R6 beliebige Reste bezeichnen, bevorzugt aber ein Wasserstoffatom oder Halogen-, Nitril-, Alkyl-, Alkoxy- oder Arylreste;
- Fig. 10: Beispiele für konjugierte D-A-D-Oligomere mit ausgedehntem Akzeptor-Block;
- Fig. 11: Beispiele für konjugierte D-A-D- / D-A-D'-Oligomere mit ausgedehnten Donor- Blöcken an beiden Enden;
- Fig. 12: Beispiele für konjugierte A-D-A'- / A-D-A-Oligomere mit ausgedehnten Akzep- tor-Blöcken an beiden Enden;
- Fig. 13: ein Absorptionsspektrum in Dichlormethan-Lösung und für eine Aufdampfschicht von DCV-2T-TPy-2T-DCV;
- Fig. 14: eine Strom-Spannungs-Kennlinie mit Beleuchtung für eine Solarzelle mit einer 20nm dicken DCV3T-Schicht und einer 5nm dicken MeO-TPD-Schicht;
- Fig. 15: eine Strom-Spannungs-Kennlinie mit und ohne Beleuchtung für eine Solarzelle mit einer 20nm dicken DCV3T-Schicht und einer 10nm dicken ZnPc-Schicht;
- Fig. 16: eine Strom-Spannungs-Kennlinie mit und ohne Beleuchtung für eine Solarzelle mit einer 20nm dicken C₆₀-Schicht und einer 15nm dicken DCV5T-Schicht;
- Fig. 17: Absorptionsspektrum von DCV5T (a)) sowie ein Fluoreszenzspektrum von DCV5T (b));
- Fig. 18: eine äußere Quantenausbeute für die in Fig. 16 vermessene Solarzelle;
- Fig. 19: eine Strom-Spannungs-Kennlinie unter Beleuchtung für eine Solarzelle auf Basis eines photoaktiven Heteroübergangs zwischen C₆₀ und DCV6T;
- Fig. 20: die chemische Struktur von Bathocuproin und Bathophenatrolin;
- Fig. 21: die chemische Struktur von MeO-TPD und Di-NPB;
- Fig. 22: eine Strom-Spannungs-Kennlinie unter Beleuchtung für eine Solarzelle nach ei- nem Beispiel 8; und
- Fig. 23: einen Vergleich einer optimierten Solarzelle nach einem Beispiel 3 mit photoakti- vem Heteroübergang zwischen DCV5T und C₆₀ mit p-dotiertem DiNPD als Lö- chertransporter (Rechtecke) mit einer analogen Struktur auf Grundlage eines pho- toaktiven Heteroübergangs aus Zink-Phthalocyanin (ZnPc) und C₆₀ (Dreiecke).

Die A-D-A'-BCO / D-A-D'-BCO (konjugierte Akzeptor-Donor-Akzeptor-Oligomere (A-DA'-Oligomere) / konjugierte Donor-Akzeptor-Donor-Oligomere (D-A-D'-Oligomere)) werden als lichtabsorbierendes, elektronenleitendes Material (ETM - ,,e*lectron transport materi-al"*) oder lichtabsorbierendes, löcherleitendes Material (HTM - ,,*hole transport material"*) in photoaktiven organischen Bauelementen mit einem photoaktiven Heteroübergängen in verschiednen Ausführungsformen verwendet. Hierbei bildet das löcherleitendes Material (HTM) den Donor des Heteroübergangs und das elektronenleitendes Material (ETM) den Akzeptor des Heteroübergangs.

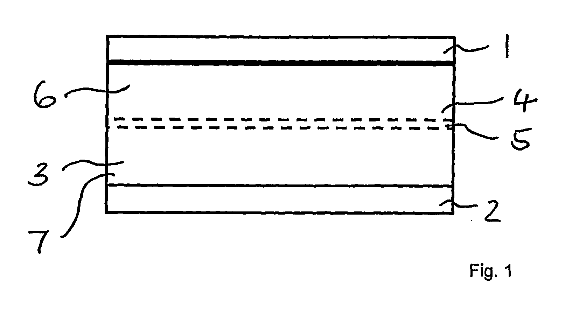

Fig. 1 zeigt eine schematische Darstellung eines photoaktiven organischen Bauelementes mit einem Kontakt 1 und einem Gegenkontakt 2 sowie einem organischen Bereich 3, der mit dem Kontakt 1 und dem Gegenkontakt 2 elektrisch verbunden ist, wobei in dem organischen Bereich 3 ein photoaktiver Bereich 4 mit einem photoaktiven Heteroübergang 5 zwischen einem elektroleitenden organischen Material 6 und einem löcherleitenden organischen Material 7 gebildet ist.

Wird das A-D-A'-BCO als löcherleitendes Material (HTM) eingesetzt, wird das zugehörige elektronenleitende Material (ETM), zum Beispiel Fulleren C₆₀, so gewählt, dass nach Lichtanregung des A-D-A'-BCO ein schneller Elektronenübergang auf das elektronenleitende Material (ETM) stattfindet. Wird das A-D-A'-BCO umgekehrt als elektronenleitendes Material (ETM) eingesetzt, wird das komplementäre löcherleitende Material (HTM) so gewählt, dass nach Lichtanregung des A-D-A'-BCO ein schneller Löcherübertrag auf das löcherleitende Material (HTM) stattfindet.

Der Heteroübergang 5 zwischen dem elektronenleitenden Material 6 und dem löcherleitenden Material 7 ist als ein flacher Heteroübergang ausgeführt, wenn die Grenzfläche zwischen dem elektronenleitenden und dem löcherleitenden Material 6, 7 als eine im wesentlichen zusammenhängende Fläche zwischen den zwei Materialbereichen gebildet ist, nämlich einem Bereich aus dem elektronenleitenden Material 6 und einem Bereich aus dem löcherleitenden Material 7.

Der Heteroübergang 5 zwischen dem elektronenleitenden und dem löcherleitenden Material 6, 7 ist ein Volumen-Heteroübergang, wenn das elektronenleitende Material 6 und das löcherleitende Material 7 zumindest teilweise miteinander vermischt sind, so dass die Grenzfläche zwischen dem elektronenleitenden und dem löcherleitenden Material 6, 7 einen Vielzahl von Grenzflächenabschnitten umfasst, die über das Volumen der Materialmischung verteilt sind

Der photoaktive Bereich 4 mit dem photoaktiven Heteroübergang 5 zwischen einem A-D-A'-BCO und einem Akzeptor-Material (elektronenleitenden Material) kann als M-i-M-, p-i-n-, M-i-p- oder M-i-n-Aufbau ausgeführt werden (M = Metall, p = p-dotierter organischer oder anorganischer Halbleiter, n = n-dotierter organischer oder anorganischer Halbleiter, i = intrinsisch leitfähiges System organischer Schichten)

Eine Ausführung als Tandemzellen kann vorgesehen sein, die als solche bekannt sind (vgl. P. Peumans et al., J. Appl. Phys., 93 (7), 3693-3723 (2003); US 4,461,922; US 6,198,091; US 6,198,092). Auch Tandemzellen aus zwei oder mehreren aufeinander gestapelten M-i-M-, p-in-, M-i-p- oder M-i-n-Dioden sind möglich (vgl. hierzu DE 103 13 232) verwendet werden.

Das photoaktive Bauelement wird in den verschiedenen Ausführungen hergestellt, indem die Schichten mittels thermischem Verdampfen in einer Hochvakuumanlage mit einem Basisdruck von 10⁻⁶ bis 10⁻⁸ mbar abgeschieden werden. Organische Materialien werden aus Keramik-Quellen verdampft, die durch Widerstandsdrähte geheizt werden. Metall-Kontakte werden aus Molybdän- oder Keramik-Schiffchen verdampft, welche direkt durch Stromfluss durch das Schiffchen geheizt werden. Dabei wird die Aufdampfrate mittels Schwingquarz-Monitoren gemessen und kontrolliert. Mischschichten werden durch simultanes Bedampfen eines Substrats aus mehreren, getrennt geheizten und durch verschiedene Schwingquarz-Monitore kontrollierte Quellen hergestellt. Die verwendeten organischen Materialien wurden vorher durch Sublimation unter Hochvakuum in einem Ofen mit Temperaturgradient gereinigt.

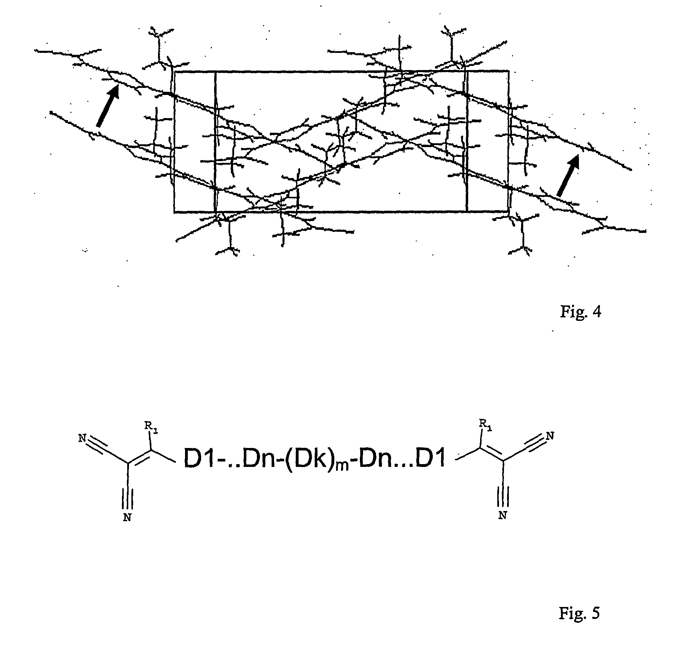

Ein einfacher Vertreter der Gruppe der A-D-A'-BCO ist DCV3T. Fig. 5 zeigt Beispiele für die chemische Struktur von Bis(dicyanovinylen)-Oligothiophen-Derivaten, wobei n ≥ 1 ist und R1 - R4 = beliebige Reste bezeichnen, bevorzugt Wasserstoff, Halogen, Nitril, Alkyl-, Alkoxy- oder Arylrest:
DCV3T: R1, R2 und R3 = Wasserstoff, R4 = Buthyl und n = 1;
DCV5T: R1, R2 und R3 = Wasserstoff, R4 = Buthyl und n = 2;
DCV7T: R1, R2 und R3 = Wasserstoff, R4 = Buthyl und n = 3;
TCV3T: R1 = Nitril, R2 und R3 = Wasserstoff, R4 = Buthyl und n = 1;

Alkylreste sind zum Beispiel Methyl, Ethyl, Propyl, Buthyl, Pentyl, Hexyl oder dergleichen, die auch verzweigt sein können, beispielsweise als Tertiärbuthyl. Arylrest sind zum Beispiel Phenyl, Naphthyl oder auch Heterozyklen mit Stickstoff oder Schwefel oder Sauerstoff im Ring. An Alkyl-, Alkoxy- und Arylreste können die peripheren Wasserstoffatome ganz oder teilweise durch Halogenatome oder Nitrilgruppen ersetzt sein.

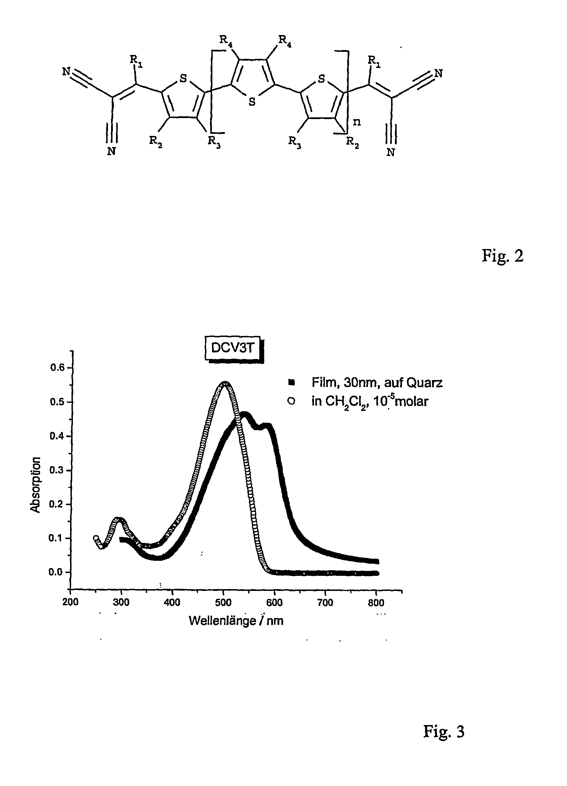

Das Absorptionsspektrum von DCV3T in dünnen Schichten zeigt im Vergleich zum Spektrum gelöster Moleküle die gewünschte Rotverschiebung (vgl. Fig. 3). Es handelt sich um eine konjugiertes A-D-A'-Oligomer, was sich am Vergleich zu Terthiophen (3T) ohne DCV-Endgruppen manifestiert. Da die elektrochemische Reduktion des 3T nicht messbar ist, zeigt sich der A-D-A'-Charakter hier am deutlichsten in der extremen Rotverschiebung der Absorption vom 3T zum DCV3T bei gleichzeitiger Erhöhung des ersten Oxidationspotentials (vgl. Tabelle 1).

Fig. 3 zeigt eine Absorptionsspektrum von DCV3T in Lösung (Kreise) und in einer 30nm dicken Aufdampfschicht auf Quarzglas (Vierecke). Das Spektrum ist in der Schicht deutlich zu längeren Wellenlängen verschoben (Rotverschiebung). Die ausgeprägte Struktur des Spektrums in der Schicht ist ein Hinweis auf eine Planarisierung der Monomerringe im Oligomer, welche für hohe Ladungsträger-Beweglichkeiten vorteilhaft ist, da sie den Überlapp der π-Orbital benachbarter Moleküle begünstigt.

**Tabelle 1**

| | Terthiophen (3T) | DCV3T |
|---|---|---|
| Erster Absoprtionspeak in CH₂Cl₂ | 336nm; | 500nm; |
| (Wellenlänge in nm und Energie in eV) | 3.69eV | 2.48eV |
| Erster Reduktionspeak in CH₂Cl₂ (vs. Fc/Fc⁺) | nicht beobachtbar in CH₂Cl₂ (d.h. < -1.7V) | -1.32V |
| Erster Oxidationspeak in CH₂Cl₂ (vs. ∼ Fc/Fc⁺) | ∼ +0.7V (umgerechnet aus +1.1V vs. Ag/AgCl) | +0.98V |

Fig. 4 zeigt eine Kristallstruktur von DCV3T. Der starke Versatz der Oligomere im Stapel begünstigt eine anziehende Wechselwirkung zwischen den Übergangsdipolmomenten bei Anregung in Phase und damit eine Rotverschiebung der erlaubten optischen Übergänge im Vergleich zur Absorption der Lösung beobachtet wird. Die Wechselwirkung zwischen den Dicyanovinyl-Akzeptor-Einheiten mit den Thiophenringen der nächsten Nachbarn ist durch Pfeile angedeutet.

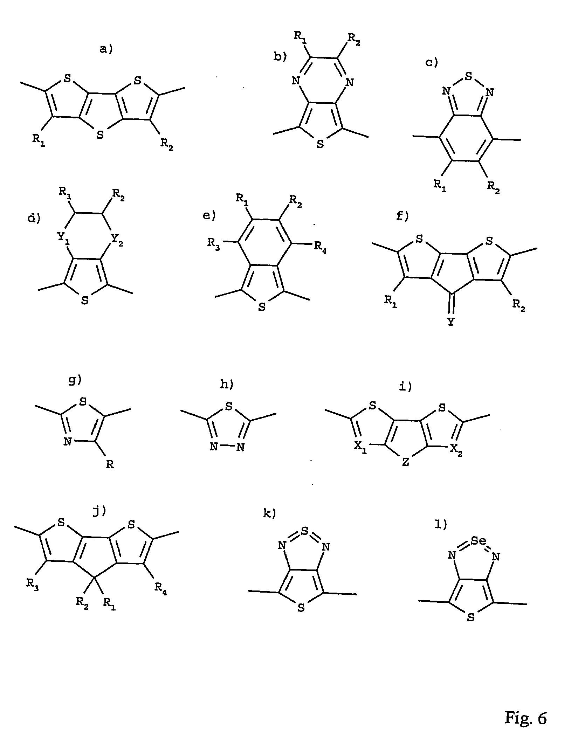

Fig. 5 zeigt eine allgemeine Strukturfolge für konjugierte A-D-A-Oligomere mit ausgedehntem Donor-Block mit Spiegel- bzw. Punktsymmetrie und Dicyano-vinylene als AkzeptorGruppe, wobei R1= n≥1 und R1-R4= beliebige Reste, bevorzugt Wasserstoff, Halogen, Nitril, Alkyl-, Alkoxy- oder Arylrest. Als Donormonomere D1-Dn und Dk können im Donorblock zum Beispiel die in Fig. 6 dargestellten Monomere in beliebiger Reihenfolge verwendet werden.

Fig. 6 zeigt weitere Beispiele für Donor-Monomere, die in A-D-A'-BCO oder D-A-D'-BCO zum Einsatz kommen können. Hier bezeichnen: X und Y = CR1 oder N, Z= S, CO, CR1R2, NR1, wobei R1 bzw. R2= beliebiger rest, bevorzugt Wasserstoff, ein Halogen-, Nitril-, Alkyl-, Alkoxy- oder Arylrest.. Die Einheiten c) und f) tragen nur bedingt Donor-Charakter und können in Kombination mit stärkeren Donor-Einheiten auch mit Akzeptor-Funktion in A-DA'- / D-A-D'-Oligomeren auftreten. Neben den gezeigten Donor-Gruppen können auch Vinyl, Phenyl, Naphthyl, Anthrazen oder andere Homo- bzw. Heterozyklen verwendet werden. Die Verbindung zum benachbarten Monomer im Oligomer geschieht bevorzugt entsprechend den gestrichelten gezeichneten Bindungen, kann aber auch an jeder anderen Stelle vorgenommen werden, die einen peripheren Wasserstoff oder einen Rest R trägt. Falls eine hier gestrichelt gezeichnete Bindung nicht zur Bindung an eine Nachbarmolekül genutzt wird, tritt hier wieder ein beliebiger Rest R auf.

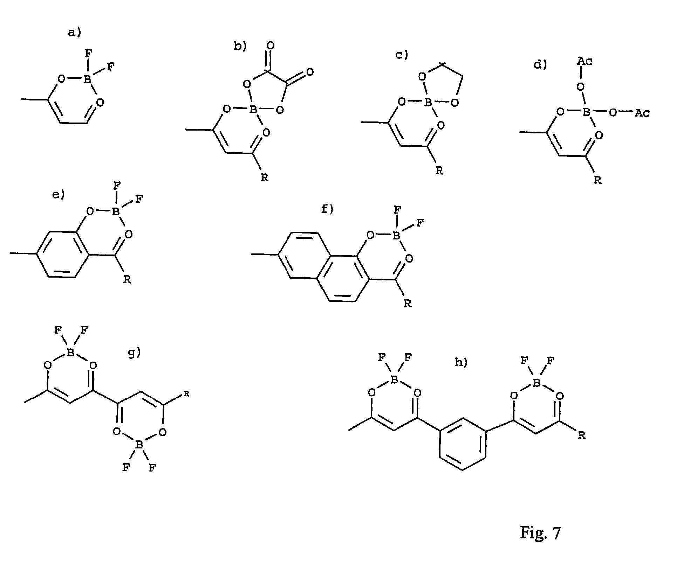

Fig. 7 zeigt Beispiele für akzeptorartige Einheiten auf Basis der Dioxaborin-Gruppe, die in A-D-A'-BCO oder D-A-D'-BCO eingesetzt werden können. In den A-D-A'-BCO nach Fig. 5 können diese zum Beispiel die Dicyano-Vinylen-Endgruppen ersetzen. R ist ein beliebiger Rest, bevorzugt aber Wasserstoff, ein Halogen-, Nitril-, Alkyl-, Alkoxy- oder Arylrest. Auch alle anderen peripheren Wasserstoffatome können durch einen beliebigen Rest R substituiert werden. Die Verbindung zum benachbarten Monomer im Oligomer geschieht bevorzugt entsprechend den gestrichelten gezeichneten Bindungen, kann aber auch an jeder anderen Stelle vorgenommen werden, die einen peripheren Wasserstoff oder einen Rest R trägt. Falls eine hier gestrichelt gezeichnete Bindung nicht zur Bindung an eine Nachbarmolekül genutzt wird, tritt hier wieder ein beliebiger Rest R auf.

Die Absorptionskante von A-D-A'-BCO lässt sich durch die Wahl der Donor-Blöcke einstellen. Eine Rotverschiebung der Absorption tritt beispielsweise ein, wenn Donor-Monomere mit tiefer liegendem LUMO wie in den Ausführungen b), c) und f) in Fig. 6 in den Donor-Block eingebaut werden.

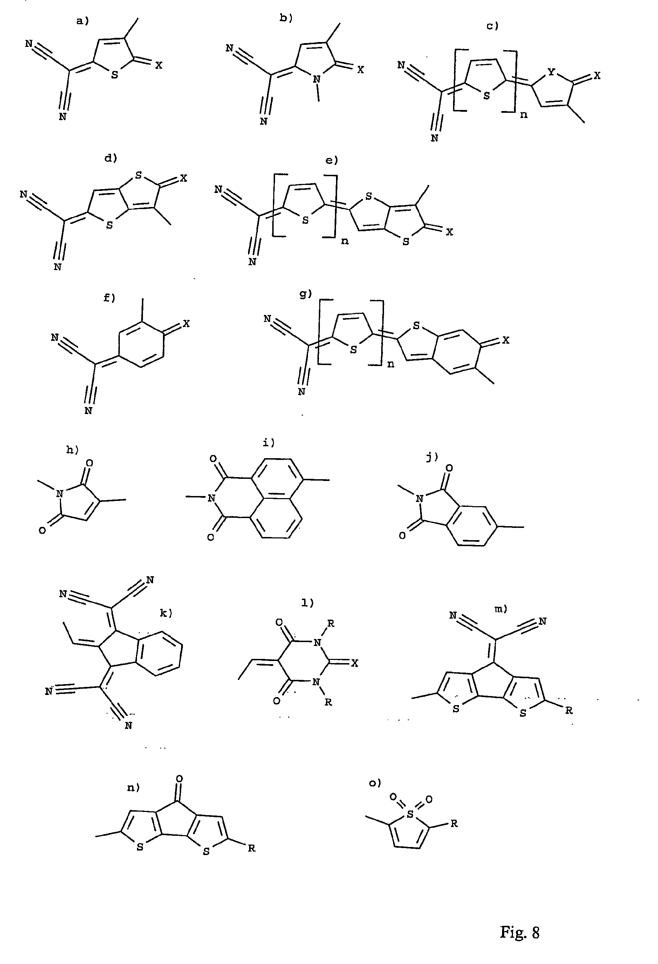

Fig. 8 zeigt weitere Beispiele für Akzeptor-Gruppen, die in A-D-A'-BCO verwendet werden können. X bezeichnet ein Sauerstoff oder Schwefel-Atom, Y bezeichnet S oder NR, R bezeichnet einen beliebigen Rest, bevorzugt aber Wasserstoff oder Halogen-, Nitril-, Alkyl-, Alkoxy- oder Arylreste.. Die Oligothiophen-Einheiten in den Molekülen c, e und g in Fig. 8 tragen durch die chinoide Struktur Akzeptorcharakter. Die Verbindung zum benachbarten Monomer im Oligomer geschieht bevorzugt entsprechend den gestrichelten gezeichneten Bindungen, kann aber auch an jeder anderen Stelle vorgenommen werden, die einen peripheren Wasserstoff oder einen Rest R trägt. Falls eine hier gestrichelt gezeichnete Bindung nicht zur Bindung an eine Nachbarmolekül genutzt wird, tritt hier wieder ein beliebiger Rest R auf.

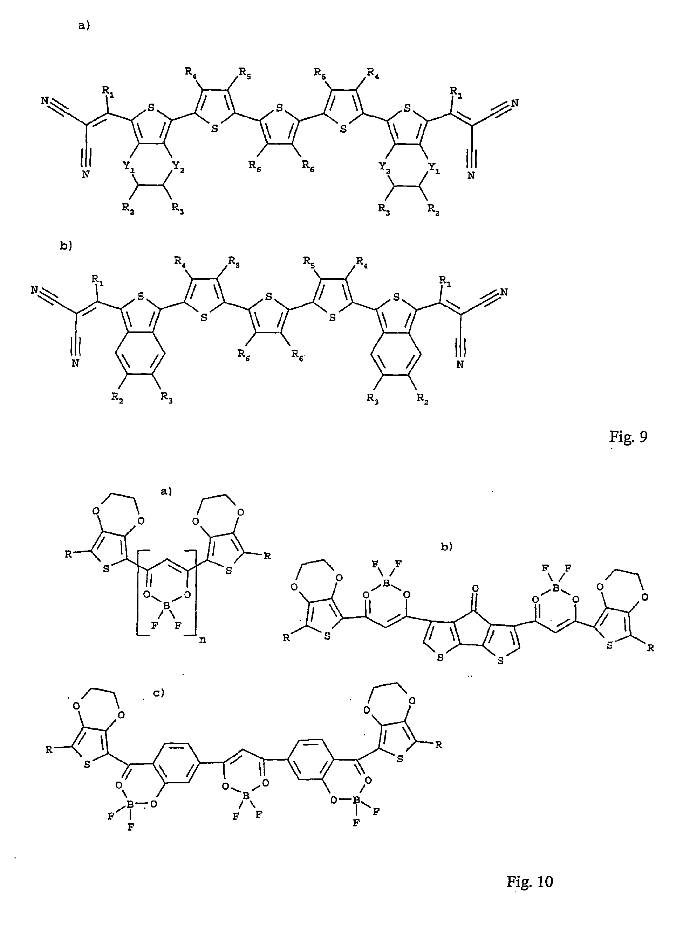

Fig. 9 zeigt Beispiele für konjugiertes A-D-A-Oligomere, bei denen an beiden Enden des ausgedehnten Donor-Blocks besonders starke Donor-Einheiten eingebaut sind. Hierbei bezeichnen Y1 und Y2 Sauerstoff- oder Schwefelatome. R1 - R6 sind beliebige Reste, bevorzugt aber Wasserstoff oder Halogen, Nitril, Alkyl-, Alkoxy- oder Arylreste..

Fig. 10 zeigt Beispiele für D-A-D-BCO-Strukturen mit ausgedehntem Akzeptor-Block. Statt der gezeigten EDOT-Gruppe, die besonders starken Donor-Charakter trägt, können auch andere Donor-Einheiten, beispielsweise die in den Fig. 6 gezeigten Donor-Einheiten verwendet werden. Ebenso können als Akzeptor-Monomer alle Einheiten aus Fig. 7 und Fig. 8 verwendet werden.

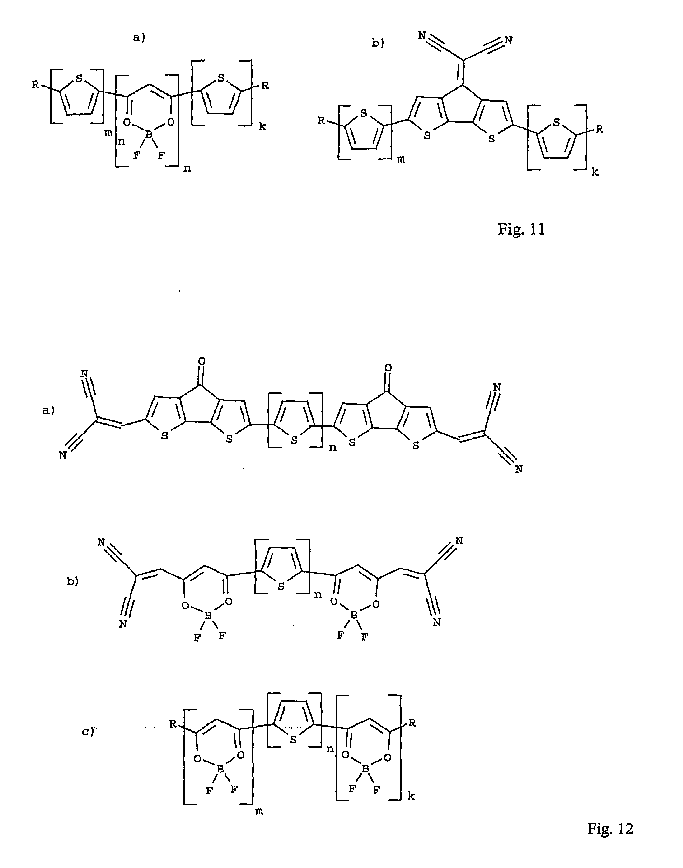

Fig. 11 zeigt Beispiele für D-A-D'-BCO mit ausgedehnten Donor-Blöcken an beiden Enden. Die peripheren Wasserstoffatome können ganz oder teilweise durch beliebige Reste, bevorzugt aber durch Halogen-, Nitril-, Alkyl-, Alkoxy- oder Arylresten substituiert sein. Es können auch andere Donor-Blöcke, zum Beispiel beliebige Kombinationen aus den in Fig. 6 gezeigten Einheiten verwendet werden. Ebenso können als Akzeptor-Monomer alle Einheiten aus Fig. 7 und Fig. 8 verwendet werden.

Fig. 12 zeigt Beispiele für A-D-A'-BCO mit ausgedehnten Akzeptor-Blöcken an beiden Enden, wobei n>0, m>1, k>1 gilt. Die peripheren Wasserstoffatome können ganz oder teilweise durch Halogen-, Nitril-, -, Alkoxy- oder Arylresten substituiert sein. Es können auch andere Donor-Einheiten, zum Beispiel beliebige Kombinationen aus den in Fig. 6 gezeigten Einheiten verwendet werden. Ebenso können als Akzeptor-Block beliebige Kombinationen der Einheiten aus Fig. 7 und Fig. 8 verwendet werden. R bezeichnet einen beliebigen Rest, bevorzugt ein Wasserstoff, Halogen, Nitril, Alkyl-, Alkoxy- oder Arylrest.

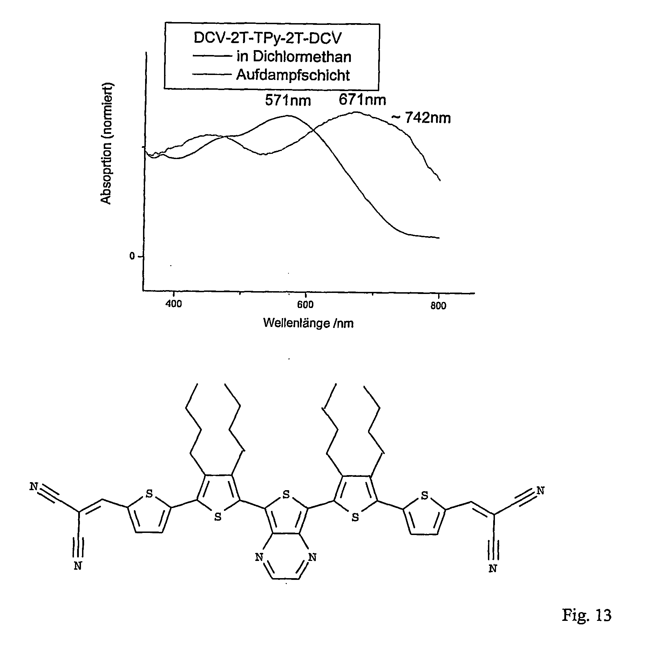

Fig. 13 zeigt Absorptionsspektren in Dichlormethan-Lösung und für eine Aufdampfschicht von DCV-2T-TPy-2T-DCV, einem Derivat von DCV5T mit einer Thienopyrazin-Gruppe im Donorblock, sowie die Strukturformel von DCV-2T-TPy-2T-DCV.

Im Folgenden werden bevorzugte Ausführungen für photoaktive organische Bauelemente mit einem strukturellen Aufbau nach Fig. 1 auf der Grundlage von A-D-A'-BCO beschrieben.

### Beispiel 1

In einem ersten Beispiel kommt DCV3T (vgl. Struktur in Fig. 5 mit n = 1 und Rest R1 = Wasserstoffatom) als Akzeptor-Molekül in einem Heteroübergang mit N,N,N',N'-Tetrakis(4-methoxyphenyl)-benzidine (MeOTPD) als Donor-Molekül zum Einsatz. Eine mögliche Schichtfolge für einen derartigen Heteroübergang, eingebaut in eine M-i-p Struktur lautet: Glassubstrat / ITO / C₆₀ (optional als Elektronen-Transportschicht) / DCV3T / MeOTPD / p-dotiertes MeOTPD / p-dotiertes Zink-Phthalocyanin (ZnPc; optional zur Verbesserung des ohmschen Kontaktes) / Gold.

Da MeOTPD weitgehend transparent ist und der Übergang zwischen C₆₀ und DCV3T nicht zur Exzitonentrennung geeignet ist, resultiert die Photostromgeneration hier ausschließlich aus der Lichtabsorption in DCV3T und der anschließenden Exzitonentrennung an der Grenzfläche zwischen DCV3T und MeOTPD.

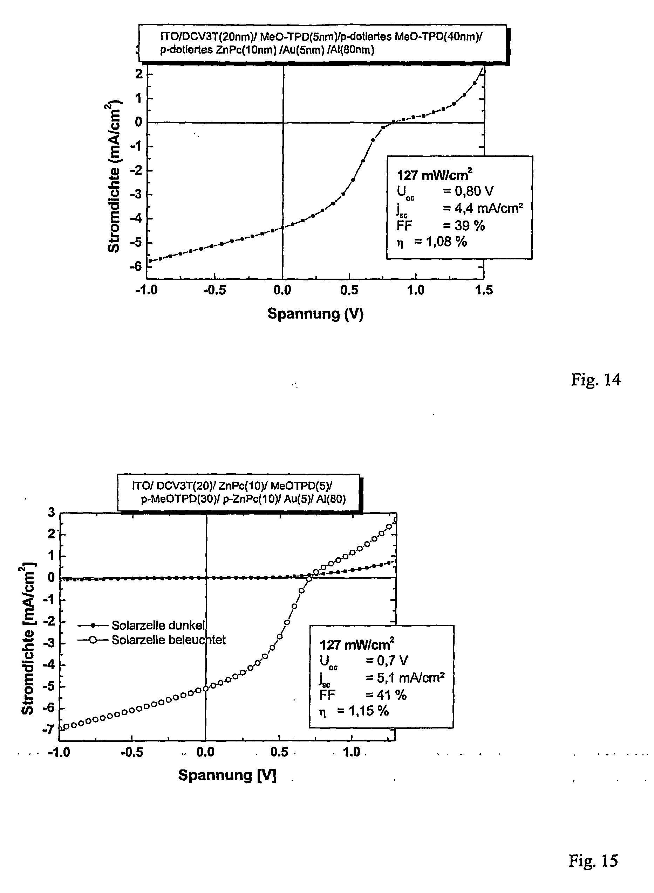

Fig. 14 zeigt eine Strom-Spannungs-Kennlinie mit Beleuchtung für eine Solarzelle mit einer 20nm dicken DCV3T-Schicht und einer 5nm dicken Schicht aus reinem MeO-TPD, welche die Exzitonen trennende Grenzfläche bereitstellen. Die genaue Schichtfolge und die Kennlinien-Daten der beleuchteten Solarzelle sind in Fig. 14 ebenfalls angegeben. Die S-Form der Kennlinie um den Wert von +1V hängt mit der mangelnden Elektroneninjektion von ITO in DCV3T zusammen. Das Problem kann durch Einfügen einer n-dotierten Zwischenschicht mit geeigneter Lage des Ferminiveaus überwunden werden.

### Beispiel 2

In einem zweiten Beispiel wird das transparente MeOTPD aus dem Beispiel 1 oben durch eine Schicht aus ZnPc ersetzt, so dass die Schichtfolge lautet: Glassubstrat / ITO / C₆₀ (optional als Elektronen-Transportschicht) / DCV3T / ZnPc / p-dotiertes MeOTPD / p-dotiertes ZnPc (optional zur Verbesserung des ohmschen Kontaktes) / Gold.

Fig. 15 zeigt Strom-Spannungs-Kennlinie mit und ohne Beleuchtung für eine Solarzelle mit einer 20nm dicken DCV3T-Schicht und 10nm dicken ZnPc-Schicht. Diese Schichten bilden die trennende Grenzfläche für Exzitonen. Die genaue Schichtfolge und die Kennlinien-Daten der beleuchteten Solarzelle sind in Fig. 14 ebenfalls angegeben.

Die Funktionsweise entspricht der im Beispiel 1 oben. Zusätzlich tritt Photostromgeneration durch Lichtabsorption auf ZnPc und Exzitonentrennung am Heteroübergang zu DCV3T auf. Dadurch wird der Kurzschlußstrom (j_{sc}) im Vergleich zu Beispiel 1 oben vergrößert.

In den Beispielen 1 und 2 wird das A-D-A'-BCO DCV3T also als Akzeptor und elektronenleitendes Material verwendet. Die vorteilhaften Eigenschaften der A-D-A'-BCO im Bezug auf Stapelverhalten, Absorption und Exzitonendynamik kommen hier schon zum Tragen. Allerdings ist diese Art der Verwendung nicht optimal, da die Elektronen auf den Akzeptor-Einheiten stark lokalisiert sind, so dass es sich bei A-D-A'-BCO mit kurzen Akzeptor-Einheiten nicht um gute Elektronenleiter handelt. Für photoaktive organische Bauelemente mit flachem Heteroübergang und dünner Absorptionsschicht ist die Elektronenbeweglichkeit aber nicht ganz so kritisch wie in Volumen-Heteroübergängen, in denen geringe Elektronenbeweglichkeiten sofort zu hohen Rekombinationsverlusten führen. Versuche, Solarzellen mit Volumen-Heteroübergang aus DCV3T und zum Beispiel ZnPc oder 4P-TPD herzustellen, zeigten dementsprechend geringe Effizienzen unter 0.5%.

Die Verwendung von A-D-A'-BCO mit Akzeptor-Einheiten aus jeweils nur einem Monomer in Volumen-Heteroübergängen ist nicht zweckmäßig. Ebenso wenig zweckdienlich sind D-A-D'-BCO mit sehr kurzem Akzeptorblock (m < 3), deren Einsatz als Elektronenleiter in Volumen-Heteroübergängen auch nicht sinnvoll ist, da sie keine ausreichend delokalisierte Elektronen-Wellenfunktion aufweisen.

### Beispiel 3

In einem dritten Beispiel wird zur weiteren Erhöhung der Lichtabsorption im roten Spektral-bereich und zur Erhöhung der Ionisierungsenergie das DCV3T aus Beispiel 1 durch DCV5T (vgl. Struktur in mit n = 2 und R1 = Wasserstoff) ersetzt, so dass sich folgende Schichtfolge ergibt: Glassubstrat / ITO / C₆₀ / DCV5T / MeOTPD / p-dotiertes MeOTPD / p-dotiertes ZnPc (optional zur Verbesserung des ohmschen Kontaktes) / Gold

Es wurde gefunden, dass in dem dritten Beispiel im Gegensatz zu den Beispielen 1 und 2 die photoaktive Grenzfläche zwischen DCV5T und C₆₀ auftritt, wobei das A-D-A'-BCO DCV5T im Gegensatz zu DCV3T als Donor im photoaktiven Heteroübergang und Löcherleiter wirkt. Der Unterschied erklärt sich aus der geringeren Ionsisierungsenergie des Moleküls DCV5T, welches den längeren Donor-Block aufweist.

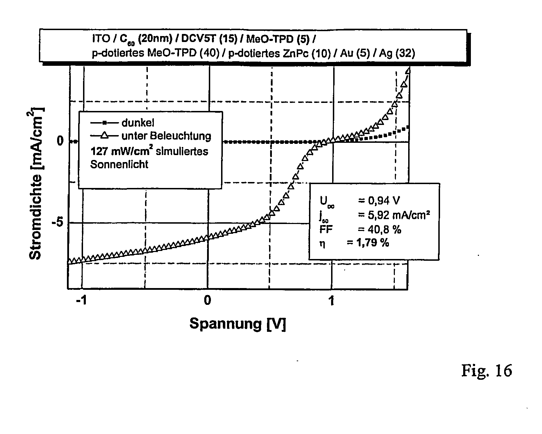

Fig. 16 zeigt eine Strom-Spannungs-Kennlinie mit und ohne Beleuchtung für eine Solarzelle mit einer 20nm dicken C₆₀-Schicht und 15nm dicken DCV5T-Schicht, welche hier als aktive Materialien wirken. Die Schichtfolge ist im Insert angegeben. Die Zelle erreicht eine Leerlaufspannung von 0,94V, eine Kurzschlussstromdichte von ca. 6mA/cm² und damit einen Wirkungsgrad von ca. 1,8%. Eine ansonsten identische Solarzelle, in der die 15nm DCV5T durch 15nm Dihexyl-Quinquethiophen (DH5T), also ein konventionelles Donor-Oligomer ersetzt wurden, erreicht nur eine Leerlaufspannung von 0,34V, eine Kurzschlussstromdichte von ca. 3.1mA/cm² und damit einen Wirkungsgrad von ca. 0.4%, wobei der Photostrom fast ausschließlich auf Absorption durch C₆₀ zurückzuführen ist.

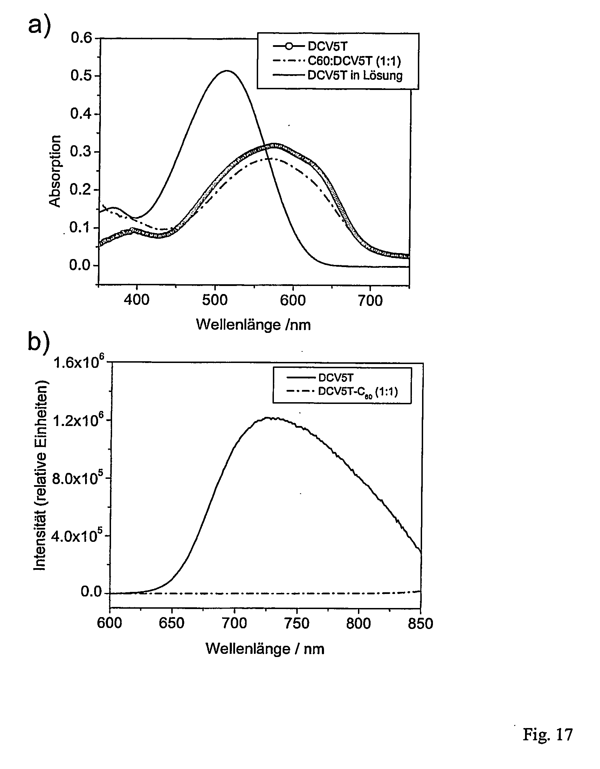

Fig. 17 zeigt a) Absorptionsspektren von DCV5T als reine Aufdampfschicht, als Mischschicht mit C₆₀ (1:1) und gelöst in CH₂Cl₂. Eindeutig sichtbar ist die Verschiebung des Absorptionspeaks beim Übergang des DCV5T von der flüssigen in die feste Phase. Fig. 17 zeigt weiterhin b) ein Fluoreszenzspektrum von reinem DCV5T und einer Mischschicht bestehend aus DCV5T und C₆₀ (1:1). In dem Spektrum der Mischschicht ist zu erkennen, dass die Fluoreszenz des DCV5T durch das C₆₀ gelöscht wird.

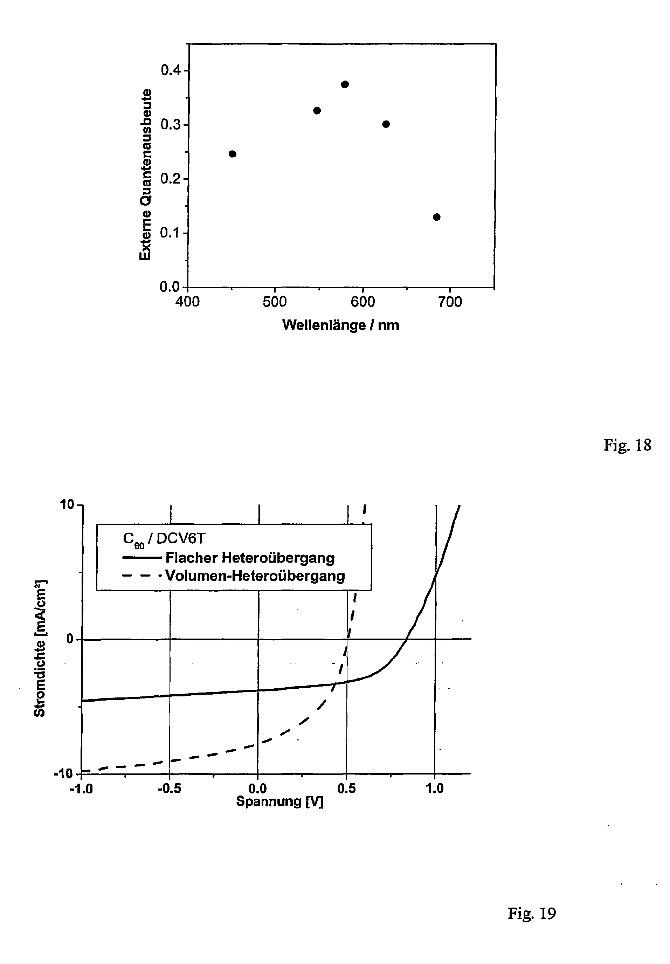

Fig. 18 zeigt eine äußere Quantenausbeute der in Fig. 16 vermessenen Solarzelle. Es ist zu erkennen, dass die Absorption des DCV5T anteilmäßig am stärksten zum Strom der Solarzelle beiträgt (siehe Quantenausbeuten bei 550-600nm).

### Beispiel 4

In einem vierten Beispiel sinkt für längere Oligothiopheneinheiten (zum Beispiel DCV6T, Struktur in Fig. 5 mit D1 = D3 = Thiophen, D2 = Dibuthyl-Thiophen und R1 = Wasserstoff oder wahlweise mit elektronenschiebendem Rest R - zum Beispiel Alkyl- oder AlkoxyGruppe - zur Sicherstellung einer ausreichend geringen Elektronenaffinität) die Ionisierungsenergie weiter, so dass auch diese A-D-A'-BCO als Donormolekül in Kombination mit C₆₀ als Akzeptormolekül zum Einsatz kommen können. Eine beispielhafte Schichtfolge für einen derartigen Heteroübergang, eingebaut in eine M-i-p-Struktur lautet: Glassubstrat / ITO / C₆₀ / DCV6T / p-dotiertes MeOTPD / p-dotiertes ZnPc (optional zur Verbesserung des ohmschen Kontaktes) / Gold.

Fig. 19 zeigt eine Strom-Spannungs-Kennlinie unter Beleuchtung mit 127mW/cm² simuliertem Sonnenlicht für Solarzellen auf Basis eines photoaktiven Heteroübergangs zwischen C₆₀ und DCV6T, ausgeführt als flacher Heteroübergang (durchgezogene Linie) oder Volumen-Heteroübergang (gestrichelte Linie - vgl. Beispiel 5 unten).

### Beispiel 5

In einem fünften Beispiel wird bei der Struktur aus Beispiel 4 statt des flachen Heteroübergangs zur Vergrößerung der aktiven Grenzfläche eine Mischschicht aus C₆₀ und DCV6T als Volumen-Heteroübergang verwendet. Es ergibt sich die Schichtfolge: Glassubstrat / ITO / C₆₀ * DCV6T (Volumenverhältnis zwischen 4:1 und 1:1) / p-dotiertes MeOTPD / p-dotiertes ZnPc (optional zur Verbesserung des ohmschen Kontaktes) / Gold.

### Beispiel 6

Alle oben genannten aktiven Schichtsysteme können statt in M-i-p-Zellen auch in Strukturen ohne dotierte Schichten eingebaut werden. Eine vorteilhafte Realisierung hierfür ist unter Verwendung des aktiven Systems aus Beispiel 4 die folgende Struktur: Glassubstrat / ITO / 3,4-polyethylenedioxythiophene:polystyrenesulfonate (PEDOT:PSS; optional als polymere löcherleitende Schicht) / DCV6T / C₆₀ / optional Schicht zur Verbesserung des Kontaktes; zum Beispiel Bathocuproin, Bathophenantrolin oder LiF / Aluminium.

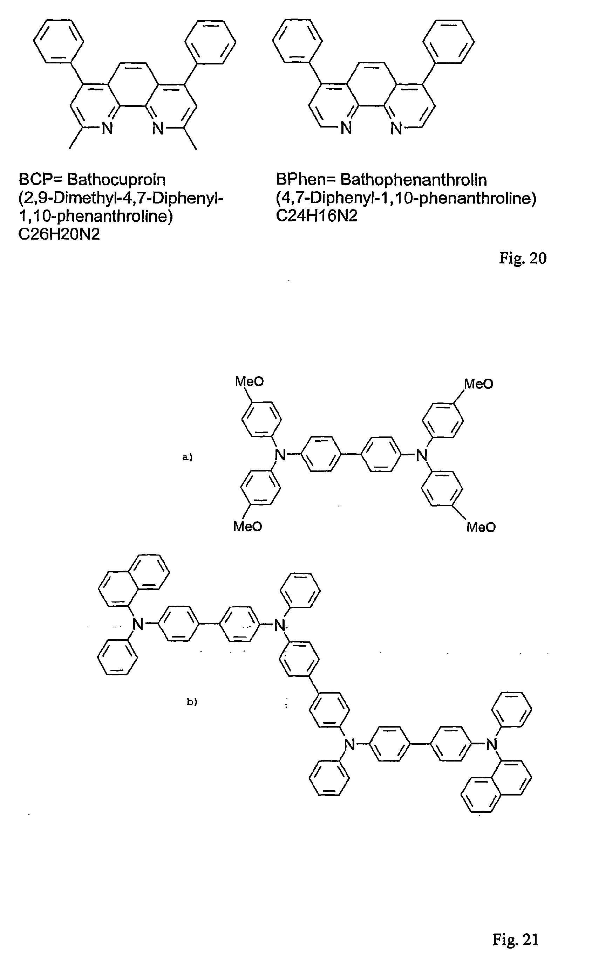

Fig. 20 zeigt die chemische Struktur von Bathocuproin und Bathophenatrolin.

### Beispiel 7

Nach einem siebten Beispiel ist eine p-i-n-Struktur vorgesehen. Beispielsweise wurde der folgenden Schichtaufbau gewählt: Glassubstrat / ITO / p-dotiertes MeOTPD / C₆₀ * DCV6T (Volumenverhältnis zwischen 4:1 und 1:1) / n-dotiertes C₆₀ / Aluminium.

### Beispiel 8

Ein achtes Beispiel betrifft eine vorteilhafte Variante von Beispiel 3. Hierbei wird der photoaktive Heteroübergang zwischen C₆₀ und DCV5T in folgende p-i-i-Struktur eingebaut: Glassubstrat / ITO / p-dotierte HTL / undotierte HTL / DCV5T / C₆₀ / BPhen / A1, wobei HTL hier ein Löchertransportmaterial mit großer Bandlücke wie MeO-TPD oder Di-NPB bezeichnet.

Fig. 21 zeigt die chemische Struktur von MeO-TPD (oben) und Di-NPB (unten).

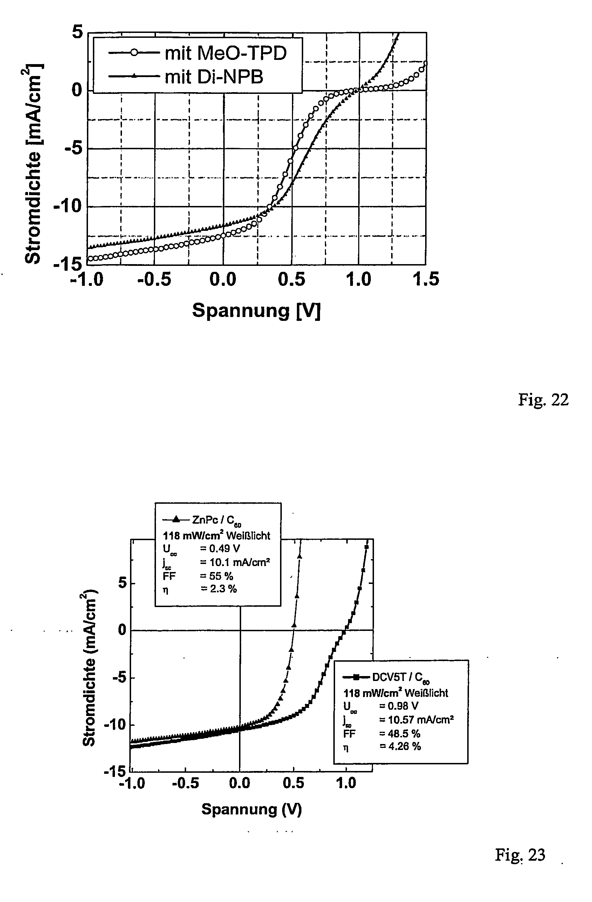

Fig. 22 zeigt eine Strom-Spannungs-Kennlinie unter Beleuchtung mit 127mW/cm² simuliertem Sonnenlicht für Solarzellen nach Beispiel 8 auf Basis eines photoaktiven Heteroübergangs zwischen C₆₀ und DCV5T in einer p-i-i-Struktur mit MeO-TPD oder Di-NPB (vgl. Fig. 21) als Löchertransportmaterial. Die Solarzelle mit Di-NPB erreicht einen energetischen Wirkungsgrad von etwa 3% für simuliertes Sonnenlicht.

Fig. 23 zeigt einen Vergleich einer optimierten Solarzelle nach Beispiel 3 mit photoaktivem Heteroübergang zwischen DCV5T und C₆₀ mit p-dotiertem DiNPD als Löchertransporter (Rechtecke) mit einer analogen Struktur auf Grundlage eines photoaktiven Heteroübergangs aus Zink-Phthalocyanin (ZnPe) und C₆₀ (Dreiecke). Die DCV5T-Zelle zeigt mit etwa 4,3% fast den doppelten Wirkungsgrad, obwohl in der ZnPc/C₆-Solarzelle zur Erhöhung des Photostroms eine 10nm dicke Mischschicht aus ZnPc und C₆₀ eingefügt ist. Ohne diesen Zusatz sinkt der Photostrom in der ZnPc/C₆₀-Zelle auf etwa 6mA/cm².

### Beispiel 9

In einem neunten Beispiel werden zur weiteren Erhöhung des Photostroms flache Heteroübergänge und Volumen-Heteroübergänge kombiniert, wobei beispielsweise die folgenden Struktur gebildet wird: Glassubstrat / ITO / p-dotiertes MeOTPD / DCV6T / C₆₀ * DCV6T (Volumenverhältnis zwischen 4:1 und 1:1) / C₆₀ / n-dotiertes C₆₀ / Aluminium.

Hier können zum Beispiel Exzitonen, die in der reinen DCV6T-Schicht angeregt werden, zu der angrenzenden Mischschicht diffundieren, wo sie in Paare freier Ladungsträger getrennt werden, wenn sie auf C₆₀-Molekale treffen. Entsprechendes gilt für Exzitonen, die in der reinen C₆₀-Schicht generiert werden.

In einem kombinierten Heteroübergang wie unter Beispiel 8 können zur weiteren Verbreiterung des Anregungsspektrums auch verschiedene Materialien kombiniert werden: Glassubstrat / ITO / p-dotiertes MeOTPD / EDOT-DCV5T / C₆₀ * DCV6T (Volumenverhältnis zwischen 4:1 und 1:1) / TCV3T / n-dotiertes C₆₀ / Aluminium.

Die reinen Schichten aus EDOT-DCV5T (Derivat von DCV5T, wobei mindestens ein Thiophenring im Donor-Block durch die EDOT-Gruppe (Fig. 6d mit Y1 = Y2 = O und R1 = R2 = H), oder TCV3T (vgl. Struktur in Fig. 2 mit n = 1 und R1 = CN) sind hier so gewählt, dass ein Löcherübertrag aus der Mischschicht auf EDOT-DCV5T und ein Elektronenübertrag aus der Mischschicht auf TCV3T barrierefrei ermöglicht wird.

## Patentansprüche

1. Organisches photoaktives Bauelement, insbesondere organische photovoltaische Zelle, mit einem Kontakt und einem Gegenkontakt sowie einem organischen Bereich, der mit dem Kontakt und dem Gegenkontakt elektrisch verbunden ist, wobei in dem organischen Bereich ein photoaktiver Bereich mit einem photoaktiven Volumen-Heteroübergang zwischen einem elektronenleitenden organischen Material und einem löcherleitenden organischen Material gebildet ist und wobei das löcherleitende organische Material aus Oligomeren nach einer der folgenden Arten gebildet ist:
- konjugiertes Akzeptor-Donor-Akzeptor-Oligomer (A-D-A'-Oligomer) mit einer Akzeptor-Einheit (A) und einer weiteren Akzeptor-Einheit (A'), die jeweils an eine Donor-Einheit (D) gebunden sind, wobei die Donor-Einheit (D) als ein ausgedehnter Donor-Block gebildet ist, indem die Donor-Einheit (D) mindestens zwei Monomere und / oder mindestens acht Atome mit einem gemeinsamen konjugierten π-Elektronensystem umfasst, die von Atomen eines oder mehrerer chemischer Elemente aus der folgenden Gruppe von Elementen gebildet sind: C, N, B, P, S, Si und O, und
- konjugiertes Donor-Akzeptor-Donor-Oligomer (D-A-D'-Oligomer) mit einer Donor-Einheit (D) und einer weiteren Donor-Einheit (D'), die jeweils an eine Akzeptor-Einheit (A) gebunden sind, wobei die Donor-Einheit (D) und die weitere Donor-Einheit (D') jeweils als ein ausgedehnter Donor-Block gebildet sind, indem die Donor-Einheit (D) und die weitere Donor-Einheit (D') jeweils mindestens zwei Monomere und / oder mindestens acht Atome mit einem gemeinsamen konjugierten π-Elektronensystem umfassen, die von Atomen eines oder mehrerer chemischer Elemente aus der folgenden Gruppe von Elementen gebildet sind: C, N, B, P, S, Si und O.

2. Organisches photoaktives Bauelement, insbesondere organische photovoltaische Zelle, mit einem Kontakt und einem Gegenkontakt sowie einem organischen Bereich, der mit dem Kontakt und dem Gegenkontakt elektrisch verbunden ist, wobei in dem organischen Bereich ein photoaktiver Bereich mit einem photoaktiven Volumcn-Heteroübergang zwischen einem elektronenleitenden organischen Material und einem löcherleitenden organischen Material gebildet ist und wobei das elektronenleitende organische Material aus Oligomeren nach einer der folgenden Arten gebildet ist:
- konjugiertes Akzeptor-Donor-Akzeptor-Oligomer (A-D-A'-Oligomer) mit einer Akzeptor-Einheit (A) und einer weiteren Akzeptor-Einheit (A'), die jeweils an eine Donor-Einheit (D) gebunden sind, wobei die Akzeptor-Einheit (A) und die wei-tere Akzeptor-Einheit (A') jeweils als ein ausgedehnter Akzeptor-Block gebildet sind, indem die Akzeptor-Einheit (A) und die weitere Akzeptor-Einheit (A') jeweils mindestens zwei Monomere und / oder mindestens acht Atome mit einem gemeinsamen konjugierten π-Elektronensystem umfassen, die von Atomen eines oder mehrerer chemischer Elemente aus der folgenden Gruppe von Elementen gebildet sind: C, N, B, P, S, Si und O, und
- konjugiertes Donor-Akzeptor-Donor-Oligomer (D-A-D'-Oligomer) mit einer Donor-Einheit (D) und einer weiteren Donor-Einheit (D'), die jeweils an eine Akzeptor-Einheit (A) gebunden sind, wobei die Akzeptor-Einheit (A) als ein ausgcdchnter Akzeptor-Block gebildet ist, indem die Akzeptor-Einheit (A) mindestens zwei Monomere und / oder mindestens acht Atome mit einem gemeinsamen konjugierten π-Elektronensystem umfasst, die von Atomen eines oder mehrerer chemischer Elemente aus der folgenden Gruppe von Elementen gebildet sind: C, N, B, P, S, Si und O.

3. Organisches photoaktives Bauelement, insbesondere organische photovoltaische Zelle, mit einem Kontakt und einem Gegenkontakt sowie einem organischen Bereich, der mit dem Kontakt und dem Gegenkontakt elektrisch verbunden ist, wobei in dem organischen Bereich ein photoaktiver Bereich mit einem photoaktiven flachen Heteroübergang zwischen einem elektronenleitenden organischen Material und einem löcherleitenden organischen Material gebildet ist, bei dem die Grenzfläche zwischen dem elektronenleitenden und dem löcherleitenden organischen Material als eine im Wesentlichen zusammenhängende Fläche zwischen zwei Materialbereichen gebildet ist, nämlich einem Bereich aus dem elektronenleitenden organischen Material und einem Bereich aus dem löcherleitenden organischen Material, und wobei das elektronenleitende und / oder das löcherleitende organische Material aus Oligomeren nach einer der folgenden Arten gebildet ist:
- konjugiertes Akzeptor-Donor-Akzeptor-Oligomer (A-D-A'-Oligomer) mit einer Akzeptor-Einheit (A) und einer weiteren Akzeptor-Einheit (A'), die jeweils an eine Doztor-Einheit (D) gebunden sind, wobei entweder zumindest die Donor-Einheit (D) als eine ausgedehnter Donor-Block oder zumindest die Akzeptor-Einheit (A) und die weitere Akzeptor-Einheit (A') jeweils als ein ausgedehnter Akzeptor-Block gebildet sind, indem die Donor-Einheit (D), die Akzeptor-Einheit (A) und die weitere Akzeptor-Einheit (A') im Fall der jeweiligen ausgedehnten Ausbildung mindestens zwei Monomere und / oder mindestens acht Atome mit einem gemeinsamen konjugierten π-Elektronensystem umfassen, die von Atomen eines oder mehrerer chemischer Elemente aus der folgenden Gruppe von Elementen gebildet sind: C, N, B, P, S, Si und O, und
- konjugiertes Donor-Akzeptor-Donor-Oligomer (D-A-D'-Oligomer) mit einer Donor-Einheit (D) und einer weiteren Donor-Einheit (D'), die jeweils an eine Akzeptor-Einheit (A) gebunden sind, wobei entweder zumindest die Akzeptor-Einheit (A) als ein ausgedehnter Akzeptor-Block oder die Donor-Einheit (D) und die weitere Donor-Einheit (D') jeweils als ein ausgedehnter Donor-Block gebildet sind, indem die Akzeptor-Einheit (A), die Donor-Einheit (D) und die weitere Donor-Einheit (D') im Fall der jeweiligen ausgedehnten Ausbildung mindestens zwei Monomere und / oder mindestens acht Atome mit einem gemeinsamen konjugierten π-Elektronensystem umfassen, die von Atomen eines oder mehrerer chemischer Elemente aus der folgenden Gruppe von Elementen gebildet sind: C, N, B, P, S, Si und O.

4. Bauelement nach mindestens einem der vorangehenden Ansprüche, **dadurch gekennzeichnet, dass** in dem konjugierten Akzeptor-Donor-Akzeptor-Oligomer (A-D-A'-Oligomer) die Donor-Einheit (D) eine Monomerfolge der Art D₁D₂ ... Dₘ₋₁Dₘ (m > 2) aufweist, wobei ein höchstes besetztes Orbital (HOMO) der Monomere D₁ und Dₘ jeweils um mindestens 0.2eV energetisch höher liegt als ein höchstes besetztes Orbital (HOMO) der übrigen Monomere D₂ ... Dₘ₋₁.

5. Bauelement nach mindestens einem der vorangehenden Anspruche, **dadurch gekennzeichnet, dass** in dem konjugierten Donor-Akzeptor-Donor-Oligomer (D-A-D'-Oligomer) die Akzeptor-Einheit (A) eine Monomerfolge der Art A₁A₂ ... Aₘ₋₁Aₘ (m > 2) aufweist, wobei ein niedrigste unbesetztes Orbital (LUMO) der Monomere A₁ und Aₘ jeweils um mindestens 0.2eV energetisch tiefer liegt als ein niedrigstes unbesetztes Orbital (LUMO) der übrigen Monomere A₂ ... Aₘ₋₁.

6. Bauelement nach mindestens einem der vorangehenden Ansprüche, **dadurch gekennzeichnet, dass** in dem konjugierten Akzeptor-Donor-Akzeptor-Oligomer (A-D-A'-Oligomer) eine Spiegel- oder eine Punktsymmetrie gebildet ist.

7. Bauelement nach mindestens einem der vorangehenden Ansprüche, **dadurch gekennzeichnet, dass** in dem konjugierten Donor-Akzeptor-Donor-Oligomer (D-A-D'-Oligomer) eine Spiegel- oder eine Punktsymmetrie gebildet ist.

8. Bauelement nach mindestens einem der vorangehenden Anspruche, **dadurch gekennzeichnet, dass** der Kontakt und / oder der Gegenkontakt als eine transparente oder eine semitransparente Elektrode ausgeführt sind.

9. Bauelement nach mindestens einem der vorangehenden Ansprüche, **dadurch gekennzeichnet, dass** zwischen dem Kontakt und dem Gegenkontakt zumindest eine anorganische Schicht aus einem oder mehreren anorganischen Materialien gebildet ist.

10. Bauelement nach mindestens einem der vorangehenden Ansprüche, **dadurch gekennzeichnen,** dass das konjugierte Akzeptor-Donor-Akzeptor-Oligomer (A-DA'-Oligomer) und / oder das Donor-Akzcptor-Donor-Oligomer (D-A-D'-Oligomer) als ein Oligomer gebildet sind, welches an mindestens eine Akzeptor-Einheit (A; A') Nitrilgruppen aufweist und bei dem mindestens eine Donor-Einheit (D; D') periphere Wasserstoffatome aufweist.

11. Bauelement nach mindestens einem der vorangehenden Ansprüche, **dadurch gekennzeichnet, dass** der Kontakt eine Anode ist und zwischen der Anode und dem photoaktiven Heteroübergang eine p-dotierte organische Schicht angeordnet ist (M-i-p-Diode).

12. Bauelement nach mindestens einem der vorangehenden Ansprüche, **dadurch gekennzeichnet, dass** der Gegenkontakt eine Kathode ist und zwischen der Kathode und dem photoaktiven Heteroübergang eine n-dotierte organische Schicht angeordnet ist (M-i-n- oder n-i-p-Diode).

13. Bauelement nach mindestens einem der vorangehenden Ansprüche, **dadurch gekennzeichnet, dass** die Donor-Einheit (D) und / oder die weitere Donor-Einheit mindestens eines der folgenden donorartigen Monomere mit oder ohne zusätzliche periphere Substituenten enthält:
a) Thiophen
b) Thienopyrazin (Fig. 6 b))
c) Benzothiadiazol (Fig. 6 c))
d) Ethylen-Dioxothiophen (EDOT) bzw. Ethylendithiothiophen (Fig. 6 d) mit Y = O /S)
e) Isothianaphthen (ITN) (Fig. 6 e)),
f) Verbrückte Dithiophencinhcit (vgL insbesondere Fig. 6 f), i) und j))
g) 1,3-Thiazol (Fig. 6 s))
h) 1,3,4-Thiadiazol (Fig. 6 h)),
i) Thieno-Thiadiazol (Fig. 6 k))
j) Thieno-Selcnodiazol (Fig. 61))
k) Phenyl,
l) Naphthyl
m) Anthrazen
n) Tetrazen
o) Pentazenp)Vinylen
q) Phenylen-Vinylen
r) Pyridine
s) Pyrimidine
t) Porphyrin
u) Phthalocyanine
v) Fluoren
w) Carbazol
x) Perylen
y) Pyren
z) Di- oder Triarylamin.

14. Bauelement nach mindestens einem der vorangehenden Ansprüche, **dadurch gekennzeichnet, dass** die Akzeptor-Einheit (A) und / oder die weitere Akzeptor-Einheit (A') mindestens eines der folgenden akzeptorartigen Monomere mit oder ohne zusätzliche periphere Substituenten enthält:
a) Cyano- Bicyano oder Tricyano-Vinylen
b) Verbrückte Dithiopheneinheit mit elektroncnziehender Brücke (Fig. 8 m), n))
c) Benzothiadiazol (Fig. 6 c))
d) Oxadiazol
e) Triazol
f) Benzimidazol
g) Quinoline
h) Quinoxaline
i) Pyrazoline
j) Naphthalen-Dicarbonsäure-Anhydride
k) Naphthalene-Dicarbonsäure-Imide
l) Naphthalene-Dicarbonsäure-Imidazolc
m) halogenierte Homo- und Heterozyklen
n) Di- oder Triarylboryl
o) Dioxaborin-Derivate (vgl. insbesondere Fig. 7)
p) Chinoide Strukturen (vgl. insbesondere Fig. 8 a) bis 8 g))
q) Aryle mit Keton- oder Dicyanomethan-Substituenten (vgl, insbesondere Fig. 8 h), j), k) und l))

15. Vorrichtung mit einer gestapelten Anordnung von mehreren aufeinander gestapelten organischen photoaktiven Bauelementen, insbesondere organischen photovoltaischen Zellen, nach mindestens einem der vorangehenden Ansprüche.

## Claims

1. Organic photoactive device, especially organic photovoltaic cell, with a contact and a countercontact as well as an organic region that is electrically connected to the contact and the countercontact, wherein a photoactive region with a photoactive bulk heterojunction between an electron-conducting organic material and a hole-conducting organic material is formed in the organic region and wherein the hole-conducting organic material is formed from oligomers according to any one of the following types:
- conjugated acceptor-donor-acceptor oligomer (A-D-A' oligomer) with an acceptor unit (A) and a further acceptor unit (A') that are each connected to a donor unit (D), wherein the donor unit (D) is formed as an extended donor block, while the donor unit (D) comprises at least two monomers and / or at least eight atoms with a common conjugated π-electron system formed by atoms of one or several chemical elements from the following group of elements: C, N, B, P, S, Si and O, and
- conjugated donor-acceptor-donor oligomer (D-A-D' oligomer) with a donor unit (D) and a further donor unit (D') that are each connected to an acceptor unit (A), wherein the donor unit (D) and the further donor unit (D') is formed as an extended donor block, while the donor unit (D) and the further donor unit (D') each comprises at least two monomers and / or at least eight atoms with a common conjugated π-electron system formed by atoms of one or several chemical elements from the following group of elements: C, N, B, P, S, Si and O.

2. Organic photoactive device, especially organic photovoltaic cell, with a contact and a countercontact as well as an organic region that is electrically connected to the contact and the countercontact, wherein a photoactive region with a photoactive bulk heterojunction between an electron-conducting organic material and a hole-conducting organic material is formed in the organic region and wherein the electron-conducting organic material is formed from oligomers according to any one of the following types:
- conjugated acceptor-donor-acceptor oligomer (A-D-A' oligomer) with an acceptor unit (A) and a further acceptor unit (A') that are each connected to a donor unit (D), wherein the acceptor unit (A) and the further acceptor unit (A') is formed as an extended acceptor block, while the acceptor unit (A) and the further acceptor unit (A') each comprises at least two monomers and / or at least eight atoms with a common conjugated π-electron system formed by atoms of one or several chemical elements from the following group of elements: C, N, B, P, S, Si and O, and
- conjugated donor-acceptor-donor oligomer (D-A-D' oligomer) with a donor unit (D) and a further donor unit (D') that are each connected to an acceptor unit (A), wherein the acceptor unit (A) is formed as an extended acceptor block, while the acceptor unit (A) comprises at least two monomers and / or at least eight atoms with a common conjugated π-electron system formed by atoms of one or several chemical elements from the following group of elements: C, N, B, P, S, Si and O.

3. Organic photoactive device, especially organic photovoltaic cell, with a contact and a countercontact as well as an organic region that is electrically connected to the contact and the countercontact, wherein a photoactive region with a photoactive flat heterojunction between an electron-conducting organic material and a hole-conducting organic material is formed, wherein the interface between the electron-conducting and the hole-conducting material is formed as a substantially cohesive surface between the two material areas, namely an area of the electron-conducting organic material and an area of the hole-conducting organic material and wherein the electron-conducting material and / or the hole-conducting organic material is / are formed from oligomers according to one of the following types:
- conjugated acceptor-donor-acceptor oligomer (A-D-A' oligomer) with an acceptor unit (A) and a further acceptor unit (A') that are each connected to a donor unit (D), wherein either at least the donor unit (D) is formed as an extended donor block or at least the acceptor unit (A) and the further acceptor unit (A') are formed as an extended acceptor block, while the donor unit (D), the acceptor unit (A) and the further acceptor unit (A') in case of the respective extended formation comprises at least two monomers and / or at least eight atoms with a common conjugated π-electron system formed by atoms of one or several chemical elements from the following group of elements: C, N, B, P, S, Si and O, and
- conjugated donor-acceptor-donor oligomer (D-A-D' oligomer) with a donor unit (D) and a further donor unit (D') that are each connected to an acceptor unit (A), wherein either at least the acceptor unit (A) acceptor unit (A) is formed as an extended acceptor block or the donor unit (D) and the further donor unit (D') are formed as an extended donor block, while the acceptor unit (A), the donor unit (D) and the further donor unit (D') in case of the respective extended formation comprises at least two monomers and / or at least eight atoms with a common conjugated π-electron system formed by atoms of one or several chemical elements from the following group of elements: C, N, B, P, S, Si and O.

4. Device according to any one of the preceding claims, **characterized in that** in the conjugated acceptor-donor-acceptor oligomer (A-D-A' oligomer) the donor unit (D) has a monomer sequence of the type D₁₂D₂...Dₘ₋₁Dₘ(m > 2), wherein a highest occupied molecular orbital (HOMO) of the monomers D₁ and Dₘ is at least 0.2eV energetically higher than a highest occupied molecular orbital (HOMO) of the other monomers D₂...Dₘ₋₁.

5. Device according to at least one of the preceding claims, **characterized in that** in the conjugated donor-acceptor-donor oligomer (D-A-D' oligomer) the acceptor unit (A) has a monomer sequence of the type A₁A₂...Aₘ₋₁Aₘ (m>2), wherein a lowest unoccupied molecular orbital (LUMO) of the monomers A₁ and Aₘ is at least 0.2eV energetically lower than a lowest unoccupied molecular orbital (LUMO) of the other monomers A₂...Aₘ₋₁.

6. Device according to at least one of the preceding claims, **characterized in that** a mirror symmetry or point symmetry is formed in the conjugated acceptor-donor-acceptor oligomer (A-D-A' oligomer).

7. Device according to at least one of the preceding claims, **characterized in that** a mirror symmetry or point symmetry is formed in the conjugated donor-acceptor-donor oligomer (D-A-D' oligomer).

8. Device according to at least one of the preceding claims, **characterized in that** the contact and / or the countercontact is / are designed as a transparent or semitransparent electrode.

9. Device according to at least one of the preceding claims, **characterized in that** at least one inorganic layer of one or more inorganic materials is formed between the contact and the countercontact.

10. Device according to at least one of the preceding claims, **characterized in that** the conjugated acceptor-donor-acceptor oligomer (A-D-A' oligomer) and/or the donor-acceptor-donor oligomer (D-A-D' oligomer) is/are formed as an oligomer that has nitrile groups on at least one acceptor unit (A; A') and in which at least one donor unit (D; D') has peripheral hydrogen atoms.

11. Device according to at least one of the preceding claims, **characterized in that** the contact is an anode and that a p-doped organic layer is arranged between the anode and the photoactive heterojunction (M-i-p diode).

12. Device according to at least one of the preceding claims, **characterized in that** the countercontact is a cathode and that an n-doped organic layer is arranged between the cathode and the photoactive heterojunction (M-i-n or n-i-p diode).

13. Device according to at least one of the preceding claims, **characterized in that** the donor unit (D) and / or the further donor unit (D') contains/contain at least one of the following donor-like monomers with or without additional peripheral substituents:
a) thiophene
b) thienopyrazine (fig. 6 b))
c) benzothiadiazole (fig. 6 c))
d) ethylene dioxothiophene (EDOT) or ethylene dithiothiophene (fig. 6 d) with Y = O/S)
e) isothianaphthene (ITN) (fig. 6 e))
f) bridged dithiophene unit (cf. in particular fig. 6 f), i) and j))
g) 1,3 thiazole (fig. 6 g))
h) 1,3,4-thiadiazole (fig. 6 h))
i) thieno-thiadiazole (fig. 6 k))
j) thieno-selenodiazole (fig. 6 l))
k) phenyl
l) naphthyl
m) anthrazene
n) tetrazene
o) pentazene-vinylene
q) phenylene vinylene
r) pyridines
s) pyrimidines
t) porphrine
u) phthalocyanines
v) fluorene
w) carbazole
x) perylene
y) pyrene
z) di- or triarylamine.

14. Device according to at least one of the preceding claims, **characterized in that** the acceptor unit (A) and/or the further acceptor unit (A') contains/contain at least one of the following acceptor-like monomers with or without additional peripheral substituents:
a) cyano-, bicyano or tricyano vinylene
b) bridged dithiophene unit with electron-attracting bridge (fig. 8 m), n))
c) benzothiadiazole (fig. 6c))
d) oxadiazole
e) triazole
f) benzimidazole
g) quinolines
h) quinoxalines
i) pyrazolines
j) naphthanene dicarboxylic acid anhydrides
k) naphthalene dicarboxylic acid imides
l) naphthalene dicarboxylic acid imidazoles
m) halogenated homocycles and heterocycles
n) di- or triarylboryl
o) dioxaborine derivatives (cf. in particular fig. 7)
p) quinoid structures (cf. in particular fig. 8 a) to 8 g))
q) aryls with ketone- or dicyanomethane substituents (cf. in particular fig. 8 h), j), k) and l))

15. Device with a stacked arrangement of several stacked organic photoactive devices, especially organic photovoltaic cells, according to at least one of the preceding claims.

## Revendications

1. Elément de construction organique photosensible, notamment cellule photovoltaïque organique, avec un contact et un contact opposé ainsi qu'avec une zone organique en connexion électrique avec ledit contact et ledit contact opposé, une zone photosensible sujette à une hétérojonction volumique photosensible entre un matériau organique conducteur d'électrons et un matériau organique conducteur de trous étant formée au sein de ladite zone organique et ledit matériau organique conducteur de trous étant formé à partir d'oligomères de l'un des types suivants:
- oligomère conjugué de type accepteur-donneur-accepteur (oligomère A-D-A') avec une unité acceptrice (A) et une autre unité acceptrice (A') qui sont chacune liées à une unité donneuse (D), ladite unité donneuse (D) se présentant sous forme d'un bloc donneur de grande étendue puisque ladite unité donneuse (D) comprend au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O, et
- oligomère conjugué de type donneur-accepteur-donneur (oligomère D-A-D') avec une unité donneuse (D) et une autre unité donneuse (D') qui sont chacune liées à une unité acceptrice (A), ladite unité donneuse (D) et l'autre unité donneuse (D') se présentant sous forme d'un bloc donneur de grande étendue puisque ladite unité donneuse (D) et ladite autre unité donneuse (D') comprennent chacune au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O.

2. Elément de construction organique photosensible, notamment cellule photovoltaïque organique, avec un contact et un contact opposé ainsi qu'avec une zone organique en connexion électrique avec ledit contact et ledit contact opposé, une zone photosensible sujette à une hétérojonction volumique photosensible entre un matériau organique conducteur d'électrons et un matériau organique conducteur de trous étant formée au sein de ladite zone organique et ledit matériau organique conducteur d'électrons étant formé à partir d'oligomères de l'un des types suivants:
- oligomère conjugué de type accepteur-donneur-accepteur (oligomère A-D-A') avec une unité acceptrice (A) et une autre unité acceptrice (A') qui sont chacune liées à une unité donneuse (D), ladite unité acceptrice (A) et ladite autre unité acceptrice (A') se présentant sous forme d'un bloc accepteur de grande étendue puisque ladite unité acceptrice (A) et ladite autre unité acceptrice (A') comprennent chacune au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O, et
- oligomère conjugué de type donneur-accepteur-donneur (oligomère D-A-D') avec une unité donneuse (D) et une autre unité donneuse (D') qui sont chacune liées à une unité acceptrice (A), ladite unité acceptrice (A) se présentant sous forme d'un bloc donneur de grande étendue puisque ladite unité acceptrice (A) comprend au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O.

3. Elément de construction organique photosensible, notamment cellule photovoltaïque organique, avec un contact et un contact opposé ainsi qu'avec une zone organique en connexion électrique avec ledit contact et ledit contact opposé, une zone photosensible sujette à une hétérojonction plane photosensible entre un matériau organique conducteur d'électrons et un matériau organique conducteur de trous étant formée au sein de ladite zone organique, l'interface entre lesdits matériaux organiques conducteur d'électrons et conducteur de trous se présentant sous forme d'une surface essentiellement continue s'étendant entre deux zones de matériaux, à savoir une zone constituée d'un matériau organique conducteur d'électrons et une zone constituée d'un matériau organique conducteur de trous, lesdits matériaux organiques conducteur d'électrons et/ou conducteurs de trous étant formés à partir d'oligomères de l'un des types suivants:
- oligomère conjugué de type accepteur-donneur-accepteur (oligomère A-D-A') avec une unité acceptrice (A) et une autre unité acceptrice (A') qui sont chacune liées à une unité donneuse (D), soit au moins ladite unité donneuse (D) se présentant sous forme d'un bloc donneur de grande étendue soit au moins ladite unité acceptrice (A) et ladite autre unité acceptrice (A') se présentant sous forme d'un bloc accepteur de grande étendue puisque ladite unité donneuse (D), ladite unité acceptrice (A) et ladite autre unité acceptrice (A') comprenant, s'ils se présentent sous leur forme de grande étendue, chacune au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O, et
- Oligomère conjugué de type donneur-accepteur-donneur (oligomère D-A-D') avec une unité donneuse (D) et une autre unité donneuse (D') qui sont chacune liées à une unité acceptrice (A), soit au moins ladite unité acceptrice (A) se présentant sous forme d'un bloc accepteur de grande étendue soit au moins ladite unité donneuse (D) et ladite autre unité donneuse (D') se présentant sous forme d'un bloc donneur de grande étendue puisque ladite unité acceptrice (A), ladite unité donneuse (D) et ladite autre unité donneuse (D') comprenant, s'ils se présentent sous leur forme de grande étendue, chacune au moins deux monomères et/ou au moins huit atomes pourvus d'un système d'électrons π commun qui sont formés par des atomes d'un ou de plusieurs éléments chimiques issus du groupe suivant d'éléments: C, N, B, P, S, Si et O.

4. Elément de construction selon au moins une des revendications précédentes, **caractérisé en ce qu'**au sein dudit oligomère conjugué de type accepteur-donneur-accepteur (oligomère A-D-A'), ladite unité donneuse (D) présente un enchaînement de monomères de type D₁D₂ Dₘ₋₁Dₘ, (m > 2), une orbitale haute occupée (orbitale HO) des monomères D₁ et Dₘ présentant un niveau d'énergie supérieur d'au moins 0,2 eV à une orbitale haute occupée (orbitale HO) des autres monomères D₂ ... Dₘ₋₁.

5. Elément de construction selon au moins une des revendications précédentes, **caractérisé en ce qu'**au sein dudit oligomère conjugué de type donneur-accepteur-donneur (oligomère D-A-D'), ladite unité acceptrice (A) présente un enchaînement de monomères de type A₁A₂ Aₘ₋₁Aₘ, (m > 2), une orbitale basse vacante (orbitale BV) des monomères A₁ et Aₘ présentant un niveau d'énergie inférieur d'au moins 0,2 eV à une orbitale basse vacante (orbitale BV) des autres monomères A₂ ... Aₘ₋₁.

6. Elément de construction selon au moins une des revendications précédentes, **caractérisé en ce qu'**au sein dudit oligomère conjugué de type accepteur-donneur-accepteur (oligomère A-D-A'), il existe une symétrie de plan ou une centro-symétrie.

7. Elément de construction selon au moins une des revendications précédentes, **caractérisé en ce qu'**au sein dudit oligomère conjugué de type donneur-accepteur-donneur (oligomère D-A-D'), il existe une symétrie de plan ou une centro-symétrie.

8. Elément de construction selon au moins une des revendications précédentes, **caractérisé en ce que** ledit contact et/ou le contact opposé sont réalisés sous forme d'une électrode transparente ou semi-transparente.

9. Elément de construction selon au moins une des revendications précédentes, **caractérisé en ce qu'**entre ledit contact et ledit contact opposé, au moins une couche inorganique est formée à partir d'un ou de plusieurs matériaux inorganiques.

10. Elément de construction selon au moins une des revendications précédentes, **caractérisé en ce que** ledit oligomère conjugué de type accepteur-donneur-accepteur (oligomère A-D-A') et/ou ledit oligomère conjugué de type donneur-accepteur-donneur (oligomère D-A-D') se présentent sous une forme d'un oligomère présentant des groupes nitrile sur au moins une unité acceptrice (A; A') et chez lequel au moins une unité donneuse (D; D') présente des atomes d'hydrogène périphériques.

11. Elément de construction selon au moins une des revendications précédentes, **caractérisé en ce que** ledit contact est une anode et une couche organique dopée p est disposée entre ladite anode et ladite hétérojonction photosensible (diode M-i-p).

12. Elément de construction selon au moins une des revendications précédentes, **caractérisé en ce que** ledit contact opposé est une cathode et une couche organique dopée n est disposée entre ladite cathode et ladite hétérojonction photosensible (diode M-i-n ou n-i-p).

13. Elément de construction selon au moins une des revendications précédentes, **caractérisé en ce que** ladite unité donneuse (D) et/ou ladite autre unité donneuse contiennent au moins un des monomères suivants de type donneur pourvus ou non de substituants périphériques supplémentaires:
a) Thiophène
b) Thiénopyrazine (fig. 6 b))
c) Benzothiadiazole (fig. 6 c))
d) Ethylène-dioxothiophène (EDOT) et/ou éthylènedithiothiophène (fig. 6 d) avec Y =O/S)
e) Isothianaphtène (ITN) (fig. 6 e)),
f) Unité de thiophène reliée par des ponts (voir notamment la fig. 6 0, i) et j))
g) 1,3-thiazole (fig. 6 g))
h) 1,3,4-thiadiazole (fig. 6 h)),
i) Thiéno-thiadiazole (fig. 6 k))
j) Thiéno-sélénodiazole (fig. 6 l))
k) Phényle
l) Naphtyle
m) Anthrazène
n) Tétrazène
o) Pentazène
p) Vinylène
q) Phénylène-vinylène
r) Pyridine
s) Pyrimidine
t) Porphyrine
u) Phtalocyanine
v) Fluorène
w) Carbazole
x) Pérylène
y) Pyrène
z) Di- ou triarylamine.

14. Elément de construction selon au moins une des revendications précédentes, **caractérisé en ce que** ladite unité acceptrice (A) et/ou ladite autre unité acceptrice (A') contiennent au moins un des monomères suivants de type accepteur pourvus ou non de substituants périphériques supplémentaires:
a) Cyano-, bicyano- ou tricyano-vinylène
b) Unité de dithiopène reliée par des ponts, avec un pont électrophile (fig. 8 m), n))
c) Benzothiadiazole (fig. 6 c))
d) Oxadiazole
e) Triazole
f) Benzimidazole
g) Quinoléine
h) Quinoxaline
i) Pyrazoline
j) Anhydrides d'acides naphtalène-dicarboxyliques
k) Imides d'acides naphtalène-dicarboxyliques
l) Imidazoles d'acides naphtalène-dicarboxyliques
m) Homo- et héterocycles halogénés
n) Di- ou triarylboryl
o) Dérivés de dioxaborine (voir notamment la fig. 7)
p) Structures quinoïdes (voir notamment les fig. 8 a) à 8 g))
q) Aryles pourvus de substituants cétone ou dicyanométhane (voir notamment les fig. 8 h), j), k) et l))

15. Dispositif avec une disposition empilée de plusieurs éléments de construction organiques empilés les uns sur les autres, s'agissant notamment de cellules photovoltaïques organiques, selon au moins une des revendications précédentes.
